# EUROPEAN PATENT APPLICATION

(11) **EP 4 841 863 A1**
(43) Date of publication of application: **18.11.2026**
(21) Application number: 25782786.5
(22) Date of filing: 20.02.2025
(51) Int. Cl.: H02J 50/60, H02J 50/80, H02J 50/90, H02J 50/12, G01R 19/165, G01R 27/02

(54) **WIRELESS POWER TRANSMISSION DEVICE AND OPERATION METHOD THEREFOR**

(30) Priority: 03.04.2024 KR 20240045075; 14.06.2024 KR 20240077456
(71) Applicant: Samsung Electronics Co., Ltd., Suwon-si, Gyeonggi-do 16677 (KR)
(72) Inventor: GU, Beomwoo, Suwon-si Gyeonggi-do 16677 (KR); KIM, Yusu, Suwon-si Gyeonggi-do 16677 (KR)
(74) Representative: Gulde & Partner
(86) International application number: PCT/KR2025/002435
(87) International publication number: WO 2025/211581

(57) **Abstract**

The present disclosure relates to a wireless power transmission device and an operation method therefor, the method comprising the steps of: receiving first information from a wireless power reception device, the first information including information related to a transmission current and a mutual loss power of a transmission coil of a wireless power transmission device; receiving second information from the wireless power reception device, the second information including information related to a received current of a reception coil of the wireless power reception device, the phase difference between the received current and the transmission current, and/or a load resistance of the wireless power reception device; measuring a first transmission current of the transmission coil; calculating a first mutual loss power on the basis of the first information and the first transmission current; calculating a first loss power on the basis of the first mutual loss power and the second information, the first loss power being the loss power generated by the magnetic flux of the transmission coil, the magnetic flux of the reception coil, and a mutual magnetic flux connected between the transmission coil and the reception coil; measuring a second power loss between the wireless power transmission device and the wireless power reception device; and identifying a foreign object on the basis of the difference between the first loss power and the second loss power being greater than or equal to a reference value.

## Description

### [Technical Field]

The disclosure relates to a wireless power transmission device, and an operation method thereof according to an embodiment.

### [Background Art]

Wireless power transmission technology using a magnetic induction method is a method of transferring power using an electromagnetic field induced in a coil, wherein a wireless power transmission device may generate an electromagnetic field by applying a current to a transmission coil, and an induced electromotive force is formed in a reception coil of a wireless power reception device due to the generated electromagnetic field, thereby enabling power to be transmitted wirelessly.

The wireless power reception device may perform in-band communication while receiving power wirelessly from the wireless power transmission device. The wireless power reception device may provide information to the wireless power transmission device by performing in-band communication. For example, the wireless power reception device may perform in-band communication, based on an amplitude shift keying (ASK) modulation method. The resonance circuit of the wireless power reception device may further include at least one element selectively connected via a switch, and the wireless power reception device may perform modulation by controlling the on/off state of the switch. Depending on the modulation in the wireless power reception device, the amplitude of the current and/or voltage applied to the transmission coil of the wireless power transmission device may be changed. The wireless power transmission device may identify the information provided by the wireless power reception device by demodulating and/or decoding the information about the amplitude of the current and/or voltage applied to the transmission coil.

Due to the presence of foreign objects, the power transmitted from the wireless power transmission device to the wireless power reception device may be lost. Foreign object detection techniques are required to increase the efficiency of power transmission.

### [Detailed Description of the Invention]

### [Technical Solution]

According to an embodiment, a wireless power transmission device may include a transmission coil, at least one controller, and memory storing instructions. The instructions, when executed by the at least one controller, may cause the wireless power transmission device to receive first information from a wireless power reception device. The first information may include information related to a transmission current of the transmission coil and mutual loss power. The instructions, when executed by the at least one controller, may cause the wireless power transmission device to receive second information from the wireless power reception device. The second information may include information related to a reception current of a reception coil of the wireless power reception device, a phase difference between the reception current and the transmission current, and/or a load resistance of the wireless power reception device. The instructions, when executed by the at least one controller, may cause the wireless power transmission device to measure a first transmission current of the transmission coil. The instructions, when executed by the at least one controller, may cause the wireless power transmission device to calculate first mutual loss power, based on the first information and the first transmission current. The instructions, when executed by the at least one controller, may cause the wireless power transmission device to calculate first loss power, based on the first mutual loss power and the second information. The first loss power may be loss power generated by magnetic flux of the transmission coil, magnetic flux of the reception coil, and/or mutual magnetic flux connected between the transmission coil and the reception coil. The instructions, when executed by the at least one controller, may cause the wireless power transmission device to measure second loss power between the wireless power transmission device and the wireless power reception device. The instructions, when executed by the at least one controller, may cause the wireless power transmission device to identify a foreign object, based on a difference between the first loss power and the second loss power being greater than or equal to a reference value.

According to an embodiment, a method of operating a wireless power transmission device may include receiving first information from a wireless power reception device. The first information may include information related to a transmission current of a transmission coil of the wireless power transmission device and mutual loss power. The method may include receiving second information from the wireless power reception device. The second information may include information related to a reception current of a reception coil of the wireless power reception device, a phase difference between the reception current and the transmission current, and/or a load resistance of the wireless power reception device. The method may include measuring a first transmission current of the transmission coil. The method may include calculating first mutual loss power, based on the first information and the first transmission current. The method may include calculating first loss power, based on the first mutual loss power and the second information. The first loss power may be loss power caused by magnetic flux of the transmission coil, magnetic flux of the reception coil, and mutual magnetic flux connected between the transmission coil and the reception coil. The method may include measuring second loss power between the wireless power transmission device and the wireless power reception device. The method may include identifying a foreign object, based on a difference between the first loss power and the second loss power being greater than or equal to a reference value.

According to an embodiment, there may be provided a non-transitory computer-readable storage medium storing at least one instruction, wherein the at least one instruction, when executed by at least one controller, comprising processing circuitry, of a wireless power transmission device, causes the wireless power transmission device to perform at least one operation. The at least one operation may include receiving first information from a wireless power reception device. The first information may include information related to a transmission current of a transmission coil of the wireless power transmission device and mutual loss power. The at least one operation may include receiving second information from the wireless power reception device. The second information may include information related to a reception current of a reception coil of the wireless power reception device, a phase difference between the reception current and the transmission current, and/or a load resistance of the wireless power reception device. The at least one operation may include measuring a first transmission current of the transmission coil. The at least one operation may include calculating first mutual loss power, based on the first information and the first transmission current. The at least one operation may include calculating first loss power, based on the first mutual loss power and the second information. The first loss power may be loss power caused by magnetic flux of the transmission coil, magnetic flux of the reception coil, and mutual magnetic flux connected between the transmission coil and the reception coil. The at least one operation may include measuring second loss power between the wireless power transmission device and the wireless power reception device. The at least one operation may include identifying a foreign object, based on a difference between the first loss power and the second loss power being greater than or equal to a reference value.

According to an embodiment, a wireless power transmission device may include: a transmission coil, at least one controller, comprising processing circuitry, and memory storing instructions. The instructions, when executed by the at least one controller, may cause the wireless power transmission device to receive first information from a wireless power reception device. The first information may include information relating to an amount of electrical power applied to the transmission coil for providing wireless charging power in relation to an amount of mutual loss power caused by friendly metal interfering with mutual magnetic flux. The mutual magnetic flux may include magnetic flux connected between the transmission coil and a reception coil of the wireless power reception device. The instructions, when executed by the at least one controller, may cause the wireless power transmission device to, while providing wireless charging power through the transmission coil, identify second information relating to a first transmission current being applied to the transmission coil. The instructions, when executed by the at least one controller, may cause the wireless power transmission device to identify third information relating to first loss power incurred while providing wireless charging power from the wireless power transmission device to the wireless power reception device. The instructions, when executed by the at least one controller, may cause the wireless power transmission device to, while providing wireless charging power through the transmission coil, detect a foreign metal object, based on the first information, the second information, and the third information.

### [Brief Description of Drawings]

The above and other aspects, features and advantages of certain embodiments of the present disclosure will be more apparent from the following detailed description, taken in conjunction with the accompanying drawings, in which:
FIG. 1A illustrates a wireless power transmission system including a wireless power transmission device and a wireless power reception device according to an embodiment;
FIG. 1B illustrates a wireless power transmission device and a wireless power reception device according to an embodiment;
FIG. 2A is a block diagram of a wireless power transmission device and a wireless power reception device according to an embodiment;
FIG. 2B illustrates a circuit of a wireless power transmission device and a wireless power reception device according to an embodiment;
FIG. 3 illustrates phases of a wireless power transmission system according to an embodiment;
FIG. 4 is a flowchart illustrating a method of operating a wireless power transmission device according to an embodiment;
FIG. 5 illustrates misalignment of a wireless power transmission system according to an embodiment;
FIG. 6 illustrates loss power according to an embodiment;
FIG. 7 illustrates a relationship between a phase difference and a load resistance according to an embodiment;
FIG. 8 is a flowchart illustrating a method of operating a wireless power transmission device associated with a maximum resistance of a transmission resistance according to an embodiment;
FIG. 9 is a flowchart illustrating a method of operating a wireless power transmission device associated with a reception resistance according to an embodiment;
FIG. 10 illustrates a relationship between a transmission resistance and a reception resistance according to an embodiment;
FIG. 11 is a flowchart illustrating a method of operating a wireless power transmission device related to inverter efficiency according to an embodiment;
FIG. 12 illustrates inverter efficiency and rectifier efficiency according to an embodiment;
FIG. 13 illustrates inverter efficiency and a load resistance according to an embodiment;
FIG. 14 illustrates mutual loss power and a transmission current according to an embodiment;
FIG. 15 illustrates mutual loss power and a load resistance according to an embodiment;
FIG. 16 is a flowchart illustrating a method of operating a wireless power transmission device and a wireless power reception device according to an embodiment; and
FIG. 17 is a flowchart illustrating a method of operating a wireless power transmission device and a wireless power reception device according to an embodiment.

### [Mode for Carrying out the Invention]

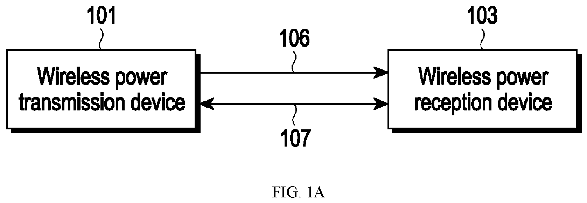

FIG. 1A illustrates a wireless power transmission system including a wireless power transmission device and a wireless power reception device according to an embodiment.

Referring to FIG. 1A, a wireless power transmission device 101 according to an embodiment may wirelessly transmit power 106 to a wireless power reception device 103. Wireless power transmission is a technology for transmitting power without a physical connection, and wireless charging technology includes, for example, an electromagnetic induction method using a coil, a resonance method using resonance, and a radio wave radiation (RF/microwave radiation) method that converts electrical energy into microwaves and transmits the same. The wireless power transmission device 101 may transmit power according to the induction method, the resonance method, or the radio wave radiation method. The wireless power transmission device 101 may be configured to perform wireless power transmission, based on at least one of the transmission methods of induction, resonance, or radio wave radiation. The wireless power transmission device 101 may be configured to support all of the induction, resonance, or radio wave radiation methods. Wireless power transfer standards may include Qi (Chi) and PowerMat. Qi may include open technologies that allow electronic devices to wirelessly transfer power to and from each other. PowerMat may include technology that uses magnetic induction. Standards that use magnetic resonance may include Rezence, Hiper, WiPower, and the like. These methods may charge multiple devices at the same time. For example, the wireless power transmission device 101 may transmit power 106 according to an induction method. When the wireless power transmission device 101 transmits power by the induction method, the wireless power transmission device 101 may include at least one of, for example, a power source, a direct current-to-direct current conversion circuit (e.g., a DC/DC converter), a direct current-to-alternating current conversion circuit (e.g., an inverter), an amplification circuit, an impedance matching circuit, at least one capacitor, at least one coil, or a communication modulation circuit. The at least one capacitor may form a resonance circuit together with the at least one coil. The wireless power transmission device 101 may include a coil capable of generating an induced magnetic field when a current flows. The process by which the wireless power transmission device 101 generates the induced magnetic field may be described as the wireless power transmission device 101 wirelessly transmitting the power 106. In addition, an induced electromotive force (or, current, voltage, and/or power) may be generated in the coil of the wireless power reception device 103 by the magnetic field generated in the surroundings according to an induction method. The process by which an induced electromotive force is generated by the coil may be described as the wireless power reception device 103 wirelessly receiving the power 106.

The wireless power transmission device 101 according to an embodiment may perform communication with the wireless power reception device 103. The wireless power transmission device 101 may exchange information with the wireless power reception device 103. For example, the wireless power transmission device 101 may receive information 107 provided from the wireless power reception device 103. The wireless power transmission device 101 may provide the information 107 to the wireless power reception device 103. For example, the wireless power transmission device 101 may perform communication with the wireless power reception device 103 according to an in-band method. The wireless power transmission device 101 may modulate data to be transmitted, for example, according to a frequency shift keying (FSK) modulation method, and the wireless power reception device 103 may provide the information 107 by modulating the same according to an amplitude shift keying (ASK) modulation method. The wireless power transmission device 101 may identify the information 107 provided by the wireless power reception device 103, based on the amplitude of the current and/or voltage applied to the transmission coil. In FIG. 1A, the wireless power reception device 103 is shown as transmitting the information 107 directly to the wireless power transmission device 101, but this is simply for ease of understanding, and those skilled in the art will understand that the wireless power reception device 103 controls the on/off of at least one switch therein. The operation of performing modulation based on the ASK modulation method and/or the FSK modulation method may be understood as the operation of transmitting data (or packets) according to the in-band communication method, and the operation of performing demodulation based on the ASK demodulation method and/or the FSK demodulation method may be understood as the operation of receiving data (or packets) according to the in-band communication method.

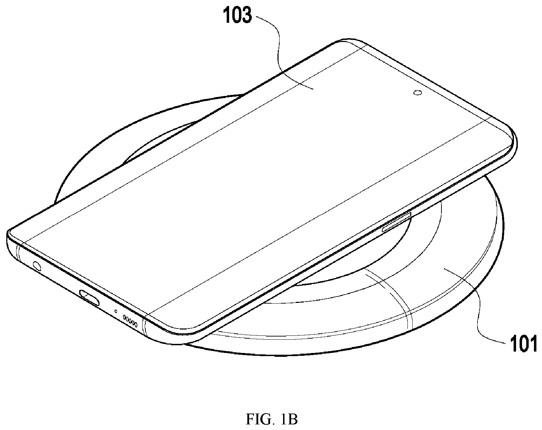

FIG. 1B is a schematic diagram of a wireless charging system according to an embodiment.

Referring to FIG. 1B, a wireless charging system according to an embodiment may include a wireless power transmission device 101 and a wireless power reception device 103. The wireless power transmission device 101 may be a charging pad that transmits wireless power based on power supplied from a charger (e.g., travel adapter (TA)). According to an embodiment, the wireless power transmission device 101 may be a device that includes a wireless power transmission function, for example, implemented as a smartphone, and the form of implementation is not limited thereto. The wireless power reception device 103 may be an electronic device, such as a smartphone or wearable device, and is not limited in its implementation. According to an embodiment, the wireless power transmission device 101 is not limited to an embodiment of a device that transmits wireless power, and the wireless power transmission device 101 may include a function of transmitting wireless power and a function of receiving wireless power. According to an embodiment, the wireless power reception device 103 is not limited to an embodiment of a device that receives wireless power, and the wireless power reception device 103 may include a function of receiving wireless power and a function of transmitting wireless power.

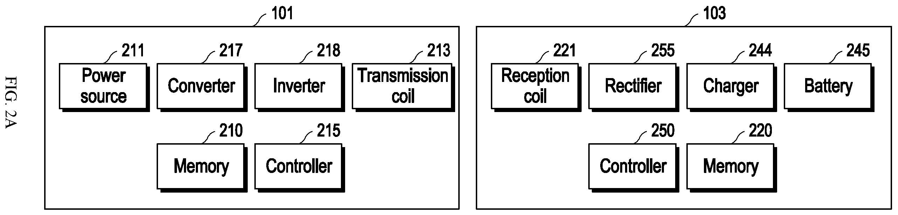

FIG. 2A is a block diagram of a wireless power transmission device and a wireless power reception device according to an embodiment.

Referring to FIG. 2A, the wireless power transmission device 101 according to an embodiment may include a controller (e.g., including processing circuitry) 215. The wireless power transmission device 101 may include memory 210. The wireless power reception device 103 may include a controller (e.g., including processing circuitry) 250. The wireless power reception device 103 may include memory 220.

As used herein, performing a specific operation by the wireless power transmission device 101 or the wireless power reception device 103 may be understood to mean that various hardware included in the wireless power transmission device 101 or the wireless power reception device 103, for example, the controller 215 or 250 including, for example, (a micro controlling unit (MCU), a field programmable gate array (FPGA), an application specific integrated circuit (ASIC), a microprocessor, or an application processor (AP)) performs a specific operation. Performing a specific operation by the wireless power transmission device 101 or the wireless power reception device 103 may be understood to mean that a controller (e.g., the controller 215 or 250) controls other hardware to perform the specific operation. Performing a specific operation by the wireless power transmission device 101 or the wireless power reception device 103 may refer to causing the controller (e.g., the controller 215 or 250) or other hardware to perform the specific operation upon execution of at least one instruction for performing a specific operation stored in a storage circuit (e.g., memory (e.g., the memory 210 or 220)) of the wireless power transmission device 101 or the wireless power reception device 103. The at least one instruction stored in memory (e.g., the memory 210 or 220) of the wireless power transmission device 101 or the wireless power reception device 103 may, when executed by the controller (e.g., the controller 215 or 250), cause the wireless power transmission device 101 or the wireless power reception device 103 to perform at least one operation. Where the controller (e.g., the controller 215 or 250) includes a processor, the processor may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions.

Referring to FIG. 2A, the wireless power transmission device 101 according to an embodiment may include at least one of a transmission coil 213, an inverter 218, a converter 217, and/or a power source (e.g., power supply) 211. The wireless power reception device 103 may include at least one of a reception coil 221, a rectifier 255, a charger 244, and/or a battery 245.

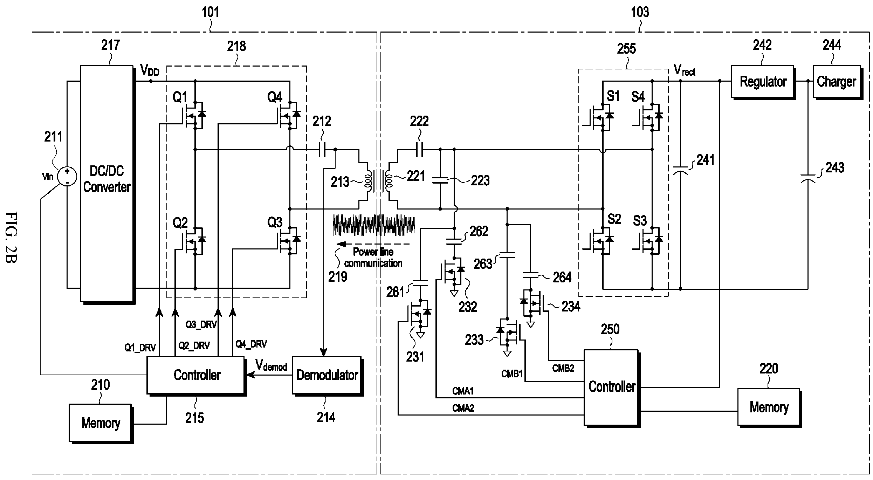

Referring to FIG. 2B, the exemplary drawing of FIG. 2A is illustrated.

FIG. 2B illustrates a circuit of a wireless power transmission device and a wireless power reception device according to an embodiment.

According to an embodiment, the wireless power transmission device 101 may include at least one of a power source 211, an inverter 218 including a plurality of switches Q1, Q2, Q3, and Q4, a capacitor 212, a transmission coil 213, a demodulation circuit 214, a controller 215, and/or a DC/DC converter 217.

According to an embodiment, the power provided by the power source 211 may be provided to the DC/DC converter 217. The power source 211 may include at least one of an interface for connecting to an external travel adapter (TA), a battery (not shown) of the wireless power transmission device 101, a charger (not shown), or a power management integrated circuit (PMIC) (not shown). The power source 211 may provide direct current power to the DC/DC converter 217, for example, but is not limited to the type of power provided. The DC/DC converter 217 may convert the voltage of the provided power and provide the same to the inverter 218. The DC/DC converter 217 may change the voltage of the input DC power to provide DC power having the changed voltage (or, drive voltage (V_{DD})) to the inverter 218. The DC/DC converter 217 may perform buck conversion and/or boost conversion, for example, and may be implemented as a three-level converter, for example, but those skilled in the art will understand that the type of converter is not limited.

The inverter 218 according to an embodiment may output alternating current power using the drive voltage V_{DD} provided from the DC/DC converter 217. The plurality of switches Q1, Q2, Q3, and Q4 may form a full bridge circuit, for example, but there is no limitation on the number of switches or the type of bridge circuit. For example, when a full bridge circuit is configured, one end of the transmission coil 213 may be connected to a connection point between the switches Q1 and Q2 via the capacitor 212, and the other end of the transmission coil 213 may be connected to a connection point between the switches Q3 and Q4. The plurality of switches Q1, Q2, Q3, and Q4 may be controlled to be in an on state, or an off state. For example, in order to generate alternating current power, the controller 215 may control the first switch Q1 and the third switch Q3 to be turned on while controlling the second switch Q2 and the fourth switch Q4 to be turned off during a first period, may control the first switch Q1 and the third switch Q3 to be turned off while controlling the second switch Q2 and the fourth switch Q4 to be turned on during a second period, and may repeat the control operations described above. The controller 215 may provide control signals (Q1_DRV, Q2_DRV, Q3_DRV, Q4_DRV) for generating the alternating current power described above to the plurality of switches Q1, Q2, Q3, and Q4. Here, not only outputting a control signal, but also refraining from outputting a control signal may be named as a control of the controller 215. For example, outputting, by the controller 215, a first control signal for generating alternating current power having a first frequency to the inverter 217 may be understood to mean that the controller 215 outputs the control signals (Q1_DRV, Q3_DRV) for controlling the switches Q1 and Q3 to be turned on during a period corresponding to the first frequency, then outputs the control signals (Q2_DRV, Q4_DRV) for controlling the switches Q2 and Q4 to be turned on during the period corresponding to the first frequency, and repeats the output operations described above. On the other hand, outputting, by the controller 215, a second control signal for generating alternating current power having a second frequency to the inverter 217 may be understood to mean that the controller 215 outputs the control signals (Q1_DRV, Q3_DRV) for controlling the switches Q1 and Q3 to be turned on during a period corresponding to the second frequency, then outputs the control signals (Q2_DRV, Q4_DRV) for controlling the switches Q2 and Q4 to be turned on during the period corresponding to the second frequency, and repeats the output operations described above. In this case, the period corresponding to the second frequency may be different from the period corresponding to the first frequency.

According to an embodiment, alternating current power generated by the inverter 218 may be applied to the transmission coil 213. The capacitor 212 may form a resonance circuit with the transmission coil 213. The transmission coil 213 may form a magnetic field based on the applied alternating current power. A portion of the magnetic field (or, magnetic flux) formed by the transmission coil 213 may pass across a cross-section of the reception coil 221 of the wireless power reception device 103. As the magnetic field passing across the cross-section of the reception coil 221 changes over time, an induced electromotive force (e.g., current, voltage, or power) may be generated in the reception coil 221.

According to an embodiment, the demodulation circuit 214 may demodulate a signal applied to the transmission coil 213 (e.g., a voltage 219 applied to both ends of the transmission coil 213) to output a demodulated signal V_{demod}. The demodulation circuit 214 may, for example, identify the amplitude or change in amplitude of the signal applied to the transmission coil 213 and generate the demodulated signal V_{demod}. The demodulation circuit 214 may output the demodulated signal V_{demod} by, for example, down-converting the frequency of the alternating current power (e.g., 100 to 210 kHz). The wireless power transmission device 101 may include a mixer and/or a multiplier circuit for removing carrier components (e.g., 100 to 210 kHz, which are frequencies of alternating current power) for wireless power transmission. Here, since a waveform in which a component by modulation of the wireless power reception device 103 and a component of alternating power of the wireless power transmission device 101 are mixed may be applied to both ends of the coil 213 of the wireless power reception device 103, the frequency component (e.g., 100 to 210 kHz) of the alternating current power is named a carrier component, and those skilled in the art will understand that the wireless power reception device 103 does not actually generate an electromagnetic wave by mixing modulated data with a carrier wave. Accordingly, the carrier component (e.g., 100 to 210 kHz, which are frequencies of alternating current power) may be removed from the voltage 219 at both ends of the transmission coil 213. The demodulation circuit 214 may additionally filter (low pass filter) and output the demodulated signal V_{demod}. The demodulation circuit 214 may include a low-pass filter. The demodulation circuit 214 may filter the voltage 219 at both ends of the transmission coil 213 and then down-convert the alternating current power by a frequency (e.g., 100 to 210 kHz) to generate the demodulated signal V_{demod}. The amplitude of the voltage 219 at both ends of the transmission coil 213 may change according to the ASK modulation of the wireless power reception device 103. According to an embodiment, the controller 215 may identify the information provided by the wireless power reception device 103, based on the demodulated signal V_{demod} output by the demodulation circuit 214. The controller 215 may, for example, perform analog-to-digital converting (ADC) on the demodulated signal V_{demod}. The controller 215 may decode the digital value obtained as a result of the ADC, and may identify the information provided by the wireless power reception device 103 according to the decoding result. The decoding method may be based on, for example, the Qi standard, but those skilled in the art will understand that there is no limitation thereto. In the embodiment described above, the demodulation circuit 214 is described as performing frequency down-conversion (e.g., carrier removal) and/or low-pass filtering, and the controller 215 performs ADC and/or decoding, but this is merely illustrative. It will be understood by those skilled in the art that the demodulation circuit 214 may be implemented to further perform at least one of ADC or decoding according to an embodiment, and the controller 215 may be implemented to further perform frequency down-conversion (e.g., carrier removal) and/or low-pass filtering according to an embodiment.

According to an embodiment, the wireless power reception device 103 may include at least one of a reception coil 221, a capacitor 222, a capacitor 223, a rectifier 255, a controller 250, a plurality of capacitors 261, 262, 263, and 264, a plurality of switches 231, 232, 233, and 234, a capacitor 241, a regulator 242, a capacitor 243, and/or a charger 244. For example, the wireless power reception device 103 may include a modulation circuit and/or a demodulation circuit. For example, the wireless power reception device 103 may perform modulation based on the ASK method, using a modulation circuit (e.g., a plurality of capacitors 261, 262, 263, and 264, and a plurality of switches 231, 232, 233, and 234). For example, the wireless power reception device 103 may perform demodulation based on the FSK demodulation method using a demodulation circuit.

According to an embodiment, the reception coil 221, the capacitor 222, and the capacitor 223 may include a resonance circuit. One end of the capacitor 222 may be connected to the reception coil 221, and the other end of the capacitor 222 may be connected to one end of the capacitor 223 and one end of the rectifier 255. One end of the capacitor 223 may be connected to the other end of the capacitor 222, and the other end of the capacitor 223 may be connected to the other end of the reception coil 221. For example, the capacitor 223 may be connected in parallel to the circuit formed by the reception coil 221 and the capacitor 222 being connected in series. The other end of the capacitor 223 may be connected to the other end of the rectifier 255.

According to an embodiment, the rectifier 255 may include a plurality of switches S1, S2, S3, and S4 configuring a full bridge circuit. One end of the resonance circuit may be connected to a connection point between the switches S1 and S2, and the other end of the resonance circuit may be connected to a connection point between the switches S3 and S4. The rectifier 255 may convert the alternating current power received through the reception coil 221 into direct current power. The controller 250 may control the on/off state of the plurality of switches S1, S2, S3, and S4 to allow the alternating current power to be converted to direct current power.

According to an embodiment, a capacitor 241 and a regulator 242 may be connected to the rectifier 255. One end of the capacitor 241 may be grounded. The regulator 242 may perform conversion (e.g., buck conversion and/or boost conversion) and/or regulation of the voltage of the rectified power output from the power conversion circuit.

According to an embodiment, the charger 244 may charge a battery (e.g., the battery 245 in FIG. 2A) using power converted and/or regulated by the regulator 242. According to an embodiment, the charger 244 may control the voltage and/or current to charge the battery according to the charging mode of the battery (e.g., a constant current (CC) mode, a constant voltage (CV) mode, or a quick charge mode). Depending on the implementation, a PMIC (not shown) may be connected to the regulator 242 in place of the charger 244.

According to an embodiment, the controller 250 may perform modulation in response to the information to be provided, using a modulation circuit (e.g., a plurality of capacitors 261, 262, 263, and 264, and a plurality of switches 231, 232, 233, and 234). The controller 250 may determine a capacitor to perform modulation among the plurality of capacitors 261, 262, 263, and 264. According to a capacitor to perform modulation, a difference in amplitude of the voltage 219 sensed by the wireless power transmission device 101 may change. For example, when the modulation is performed using only one capacitor 261, it is assumed that the difference in the amplitude of the voltage 219 sensed by the wireless power transmission device 101 (e.g., the difference between a maximum amplitude of the voltage 219 while the switch 231 is in the on state and a maximum amplitude of the voltage 219 while the switch 231 is in the off state) is a first value. In this case, the capacitors 262, 263, 264 are not used for modulation, so that the switches 232, 233, and 234 may remain in the off state. On the other hand, when modulation is performed using the capacitor 261 and the capacitor 262, the difference in amplitude of the voltage 219 sensed by the wireless power transmission device 101 (e.g., the difference between a maximum amplitude of the voltage 219 while the switches 231 and 232 are in the on state and a maximum amplitude of the voltage 219 while the switches 231 and 232 are in the off state) is a second value, which may be greater than the first value. In this case, the capacitors 263 and 264 are not used for modulation, and thus the switches 233 and 234 may remain in the off state. The wireless power reception device 103 may adjust the degree of modulation (or, the depth of modulation) by adjusting a capacitor to perform modulation among the plurality of capacitors 261, 262, 263, and 264. As described above, the controller 250 may output and/or refrain from outputting at least some of the control signals CMA1, CMA2, CMB1, and CMB2 so that the switches corresponding to the undetermined capacitors remain in the off state while performing modulation using the determined capacitors. For example, the capacitance of the capacitor 262 may be smaller than the capacitance of the capacitor 261, and the capacitance of the capacitor 264 may be smaller than the capacitance of the capacitor 263, but this is merely an example and there is no limitation on the magnitude of the capacitances, and they may be the same.

As described above, modulation in the wireless power reception device 103 may result in a difference in the amplitude of the voltage 219 at the transmission coil 213 (e.g., a difference between a maximum amplitude while the at least one switch in the wireless power reception device 103 is in the on state and a maximum amplitude while the at least one switch in the wireless power reception device 103 is in the off state). The difference in the amplitude of the voltage 219 at the transmission coil 213 according to the modulation may cause a change in the voltage applied to the capacitors included in the wireless power transmission device 101. For example, a capacitor to which a direct current voltage is applied is preferably applied with a voltage of a constant value, but the voltage applied to that capacitor may also change in response to modulation of the wireless power reception device 103.

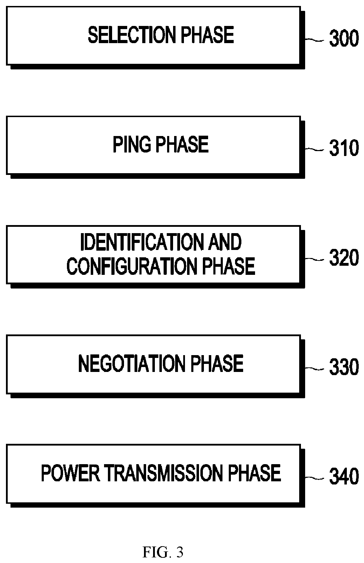

FIG. 3 illustrates phases of a wireless power transmission system according to an embodiment.

Referring to FIG. 3, the phases of the wireless power transmission system may include at least one of a selection phase 300, a ping phase 310, an identification and configuration phase 320, a negotiation phase 330, and/or a power transmission phase 340. The phases of the wireless power transmission system may conform to, for example, but are not limited to, the Qi standard.

The wireless power transmission device 101 according to an embodiment may perform an operation corresponding to at least one of the phases of FIG. 3. The wireless power transmission device 101 according to an embodiment may not perform an operation corresponding to at least one of the phases of FIG. 3.

According to an embodiment, in the selection phase 300, the wireless power transmission device 101 may monitor whether an object (e.g., the wireless power reception device 103 or a foreign object) exists. For example, the wireless power transmission device 101 may detect the object (e.g., the wireless power reception device 103 or the foreign object), based on the application of a ping signal. Based on the detection of the object (e.g., the wireless power reception device 103 or the foreign object), the wireless power transmission device 101 may transition to the ping phase 310. In the ping phase 310, the wireless power transmission device 101 may identify whether the detected object (e.g., the wireless power reception device 103 or the foreign object) is a receiver (e.g., the wireless power reception device 103). For example, the wireless power transmission device 101 may apply a digital ping signal to the transmission coil 213. Based on receiving a response corresponding to the digital ping signal, the wireless power transmission device 101 may identify that the detected object is a receiver (e.g., the wireless power reception device 103). The wireless power transmission device 101 may perform at least one operation corresponding to the identification and configuration phase 320 with the wireless power reception device 103, and the corresponding operation may follow, for example, but not limited to, the Qi standard. For example, the wireless power transmission device 101 may receive, from the wireless power reception device 103, an identification packet and/or a configuration packet. For example, the identification packet may include information about a version of a standard (e.g., a wireless power consortium (WPC) version) and/or a unique code of a terminal manufacturer. For example, the configuration packet may include information about a power class and/or power to be required. Based on the identification packet and/or the configuration packet, the wireless power transmission device 101 may identify information about a terminal manufacturer, a version of a standard, and/or a maximum received power. As described above, the wireless power transmission device 101 and the wireless power reception device 103 may perform in-band communication. In case that the wireless power transmission device 101 fails to acquire data from the wireless power reception device 103 (e.g., fails to identify that valid data is being acquired as a result of demodulation) during application of the digital ping signal, the wireless power transmission device 101 may determine that a foreign object has been placed. Upon successful completion of the operations in the identification and configuration phase 320, the wireless power transmission device 101 may perform at least one operation corresponding to the negotiation phase 330, and the corresponding operation may follow, for example, but not limited to, the Qi standard. In the negotiation phase 330, the wireless power transmission device 101 may exchange information (e.g., parameters) for transmitting power with the wireless power reception device 103. After the negotiation phase 330, the wireless power transmission device 101 may enter the power transmission phase 340 and may apply power for charging. In the power transmission phase 340, the wireless power transmission device 101 may control the transmission of power, based on information (e.g., parameters) received from the wireless power reception device 103.

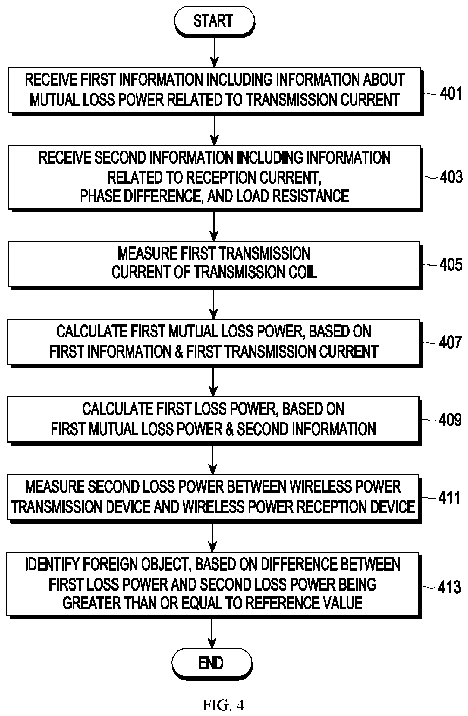

The operations of the wireless power transmission device 101 may be described in detail with reference to the embodiments described above (e.g., the embodiments of FIGS. 1A, 1B, 2A, 2B and 3) and embodiments which will be described below (e.g., the embodiments of FIGS. 4 to 17). Each of these embodiments is provided in separate drawings and in separate paragraphs, but this is for convenience of description only, and at least some of the embodiments described above and at least some of the embodiments which will be described later may be applied together. At least some of the embodiments described above and at least some of the embodiments which will be described below may be omitted.

Referring to the embodiments which will be described later (e.g., the embodiments of FIG. 4 through 17), loss power of the wireless power transmission device 101 and identification of foreign objects based on loss power will be described.

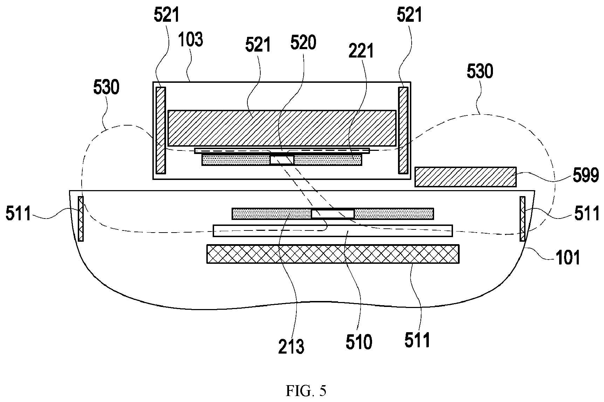

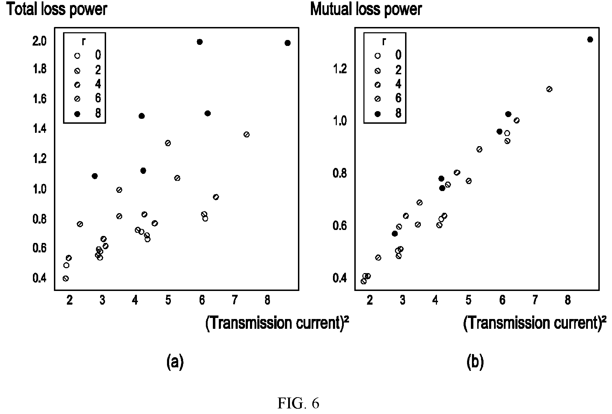

FIG. 4 is a flowchart illustrating a method of operating a wireless power transmission device according to an embodiment. FIG. 5 illustrates misalignment of a wireless power transmission system according to an embodiment. FIG. 6 illustrates loss power according to an embodiment.

With reference to FIGS. 4, 5, and 6, mutual loss power and total loss power may be described. FIG. 5 is a cross-sectional view of a wireless power transmission device 101 and a wireless power reception device 103. In FIG. 5, the wireless power transmission device 101 may include a ferrite 510, a friendly metal 511, and a transmission coil 213. The friendly metal 511 is a metal included in the wireless power transmission device 101, and there are no restrictions on where the friendly metal 511 is disposed. In FIG. 5, the wireless power reception device 103 may include a reception coil 221, a ferrite 520, and a friendly metal 521. The friendly metal 521 is a metal included in the wireless power reception device 103, and there are no restrictions on where the friendly metal 521 is disposed. In the following, friendly metals (e.g., reference numerals 511, 521, 213, and 221 in FIG. 5) may be concepts that include the friendly metal 511 of the wireless power transmission device 101, the friendly metal 521 of the wireless power reception device 103, the transmission coil 213, and/or the reception coil 221. FIG. 5 illustrates the presence of a foreign object 599 on the wireless power reception device 103. In FIG. 5, mutual magnetic flux 530 connected between the transmission coil 213 of the wireless power transmission device 101 and the reception coil 221 of the wireless power reception device 103 may be formed along the center of the reception coil 221, even when a misalignment of the wireless power transmission device 101 and the wireless power reception device 103 occurs. For example, the mutual magnetic flux 530 may be magnetic flux interlinked with the reception coil 221 and inducing a voltage among the magnetic fluxes generated by the transmission coil 213. For example, when two coils (e.g., the transmission coil 213 and reception coil 221) share the same magnetic field, the shared magnetic field (e.g., mutual flux 530) may act as a medium to deliver information. FIG. 6 illustrates a graph of transmission current and loss power (e.g., total loss power in (a) of FIG. 6, and mutual loss power in (b) of FIG. 6) of the transmission coil 213 of the wireless power transmission device 101. In FIG. 6, "r" may be a value corresponding to a misalignment of the wireless power transmission device 101 and the wireless power reception device 103 (e.g., a distance [mm] corresponding to the misalignment). The transmission current may be a current flowing in the transmission coil 213. The total loss power may include the loss power generated in the friendly metal (e.g., reference numerals 511, 521, 213, and/or 221 of FIG. 5) and/or the foreign object 599 by the magnetic flux of the transmission coil 213, the magnetic flux of the reception coil 221, and the mutual magnetic flux connected between the transmission coil 213 and the reception coil 221 (e.g., reference numeral 530 in FIG. 5). The mutual loss power may include loss power generated in the friendly metal (e.g., reference numerals 511, 521, 213, and/or 221 of FIG. 5) and/or the foreign object 599 by the mutual magnetic flux (e.g., reference numeral 530 of FIG. 5) connected between the transmission coil 213 and the reception coil 221. The total loss power (e.g., P_{FM}) may be the sum of the mutual loss power (e.g., P_{FM_M}), the TX loss power (e.g., P_{FM_Tx}), and the RX loss power (e.g., P_{FM_Rx}) (e.g., Equation 1).${P}_{FM} = {P}_{FM_Tx} + {P}_{FM_Rx} + {P}_{FM_M}$ (Equation 1)

The mutual loss power may be proportional to the square of the mutual current (e.g., I_{M}) (e.g., Equation 2).${P}_{FM_M} = {R}_{FM_M} * {{I}_{M}}^{2}$ (Equation 2)

In Equation 2, R_{FM_M} may be a mutual resistance. The mutual resistance may be a resistance corresponding to the mutual magnetic flux (e.g., reference numeral 530 in FIG. 5) connected between the transmission coil 213 and the reception coil 221 in a T-type equivalent circuit of loss power. The mutual resistance may be calculated by Equation 2, based on the mutual loss power and mutual current.

The mutual current may be the sum (e.g., sum of vectors) of the transmission current and the reception current. The transmission current may be a current flowing in the transmission coil 213. The reception current may be a current flowing in the reception coil 221. For example, the mutual current (e.g., I_{M}), the transmission current (e.g., Iₜₓ), and the reception current (e.g., Iᵣₓ) may satisfy Equation 3. ${I}_{M} = \sqrt{{\left({I}_{tx}+{I}_{rx}cosφ\right)}^{2} + {\left({I}_{rx}sinφ\right)}^{2}} , φ = Phase difference between {I}_{tx} and {I}_{rx}$ (Equation 3)

In Equation 3, φ may be a phase difference between the transmission current and the reception current.

Referring to FIGS. 5 and 6, even if misalignment of the wireless power transmission device 101 and the wireless power reception device 103 occurs, the change in the reluctance (e.g., magnetoresistance) of the flux path that determines the magnitude of the mutual flux 530 may be less than the total flux generated by the transmission coil 213. Accordingly, the mutual loss power (e.g., P_{FM_M}) may have a linearity with respect to the square of the transmission current (e.g., Iₜₓ) of the transmission coil 213 (e.g., Equation 4).${{P}_{FM_M}}^{\left({est}_{¯}\right)} = {α}_{FMM} {I}_{tx}^{2} + {α}_{FMM , DC}$ (Equation 4)

The TX loss power (e.g., P_{FM_Tx}) of Equation 1 may be loss power by the transmission current (e.g., Iₜₓ) in a T-type equivalent circuit of the loss power. An estimated value (e.g., P_{FM_Tx}^{(est)}) of the TX loss power (e.g., P_{FM_Tx}) may be calculated by Equation 5.${{P}_{FM_tx}}^{\left(est\right)} = \left(R{′}_{tx}-{{R}_{FM_M}}^{\left(est\right)}-{R}_{coil_tx}\right) {{I}_{tx}}^{2}$ (Equation 5)

In Equation 5, R'ₜₓ may be a transmission resistance. The transmission resistance may be a resistance measured across the transmission coil 213 while mutual magnetic flux (e.g., reference numeral 530 in FIG. 5) is connected between the transmission coil 213 and the reception coil 221. The wireless power transmission device 101 may measure a transmission resistance (e.g., a resistance measured in the transmission coil 213) while mutual magnetic flux (e.g., reference numeral 530 in FIG. 5) is connected between the transmission coil 213 and the reception coil 221. For example, the wireless power transmission device 101 may measure the transmission resistance in the ping phase 310. For example, the wireless power transmission device 101 may also measure the transmission resistance in a phase (e.g., phases 320, 330, or 340 of FIG. 3) different from the ping phase 310.

In Equation 5, R_{FM_M}^{(est)} may be the mutual power loss calculated by Equation 4.

In Equation 5, R_{coil_rx} may be a basic resistance of the transmission coil 213. The basic resistance of the transmission coil 213 may be a value identified by an LCR meter in a state in which no mutual flux (e.g., reference numeral 530 in FIG. 5) is connected between the transmission coil 213 and the reception coil 221.

The RX loss power (e.g., P_{FM_Rx}) of Equation 1 may be the loss power due to the reception current (e.g., Iᵣₓ) in the T-type equivalent circuit of loss power. An estimated value (e.g., P_{FM_Rx}^{(est)}) of the RX loss power (e.g., P_{FM_Rx}) may be calculated by Equation 6.${{P}_{FM_rx}}^{\left(est\right)} = \left(R{{′}_{rx}}^{\left(est\right)}-{{R}_{FM_M}}^{\left(est\right)}-{R}_{coil_rx}\right) {{I}_{rx}}^{2}$ (Equation 6)

In Equation 6, R'ᵣₓ^{(est)} may be an estimated value of the reception resistance (e.g., R'ᵣₓ). The reception resistance (e.g., R'ᵣₓ) may be the resistance in the reception coil 213 while mutual magnetic flux (e.g., reference numeral 530 in FIG. 5) is connected between the transmission coil 213 and the reception coil 221. For example, the reception resistance (e.g., R'ᵣₓ) may be proportional to the transmission resistance (e.g., R'ₜₓ). The wireless power transmission device 101 may calculate the reception resistance (e.g., R'ᵣₓ^{(est)}) based on the transmission resistance (e.g., R'ₜₓ) (e.g., Equation 7). Equation 7 may be a linear equation between the transmission resistance (e.g., R'ₜₓ) and the reception resistance (e.g., R'ᵣₓ^{(est)}).$R {′}_{rx}^{\left(est\right)} = γR {′}_{tx} + {γ}_{DC}$ (Equation 7)

In Equation 6, R_{FM_M}^{(est)} may be the mutual power loss calculated by Equation 4.

In Equation 6, R_{coil_rx} may be a basic resistance of the reception coil 221. The basic resistance of the reception coil 221 may be a value identified by an LCR meter in a state in which no mutual flux (e.g., reference numeral 530 in FIG. 5) is connected between the transmission coil 213 and the reception coil 221.

According to an embodiment, the wireless power transmission device 101 may calculate a mutual loss power based on a relationship between the transmission current and the mutual loss power, calculate a total loss power based on the calculated mutual loss power, and detect a foreign object based on a difference between the calculated total loss power (e.g., P_{FM}^{(est)}) and the measured total loss power (e.g., P_{FM}^{(meas)}) (e.g., P_{FM} Error = P_{FM}^{(meas)} - P_{FM}^{(est)}). This is explained in more detail below.

At least some of the operations of FIG. 4 may be omitted. The sequence of operations of the operations of FIG. 4 may be changed. Operations other than the operations of FIG. 4 may be performed before, during, or after performing the operations of FIG. 4.

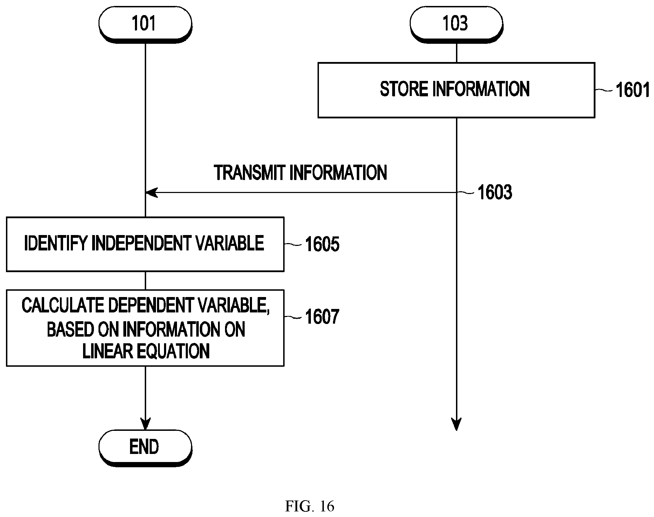

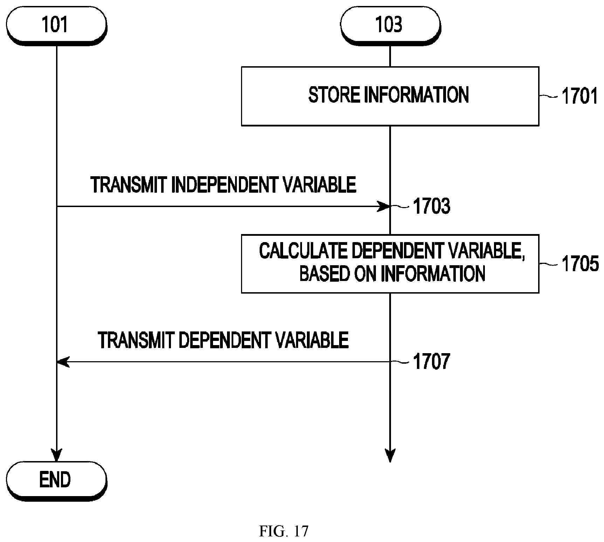

Referring to FIG. 4, in operation 401, the wireless power transmission device 101 (e.g., the controller 215) may receive first information from the wireless power reception device 103 including information about mutual loss power related to transmission current according to an embodiment. For example, the wireless power transmission device 101 may receive the first information according to an in-band communication method (e.g., via the transmission coil 213). For example, the wireless power transmission device 101 may receive the first information according to an out-of-band communication method (e.g., via a communication circuit). There is no limitation on a method in which the wireless power transmission device 101 receives the first information. According to an embodiment, the wireless power transmission device 101 may receive the first information in the negotiation phase 330 for transmitting power to the wireless power reception device 103. According to an embodiment, the first information may include information relating to an amount of power applied to the transmission coil 213 and associated with an amount of mutual loss power caused by a friendly metal (e.g., reference numerals 511, 521, 213, and/or 221 in FIG. 5) interfering with the mutual magnetic flux. For example, in connection with the first information, "power applied to the transmission coil 213" may include one of transmission current applied to the transmission coil 213, transmission power applied to the transmission coil 213, output power (or output current) of the inverter 218 electrically connected to the transmission coil 213, input power (or input current) of the inverter 218, or power (or current) at any point of the wireless power transmission device 101. For example, the first information may include information about the slope and intercept of a linear equation between the mutual loss power and the power applied to the transmission coil 213. For example, the first information may include information about a matching table between values corresponding to the mutual loss power and values corresponding to the power applied to the transmission coil 213. According to an embodiment, the first information may include information related to the transmission current of the transmission coil 213 and mutual loss power. For example, the information related to the transmission current and mutual loss power (e.g., the first information) may be information about a linear equation, information about a matching table, or information about a value of the mutual loss power, and this may be understood with reference to the embodiments of FIGS. 16 and 17. Detailed explanations thereof may be as follows.

In connection with operation 401, referring to the embodiment of FIG. 16 which will be described later, the information (e.g., the first information) related to the transmission current and the mutual loss power may be information about a linear equation between the mutual loss power and the transmission current. Referring to the embodiment of FIG. 16 which will be described later, the information (e.g., the first information) related to the transmission current and the mutual loss power may be information about a matching table of the transmission current and the mutual loss power. Referring to the embodiment of FIG. 17 which will be described later, the information (e.g., the first information) related to the transmission current and the mutual loss power may be information about a value of the mutual loss power. In connection with operation 401, the embodiment of FIG. 16 will be described herein, and the embodiment of FIG. 17 will be described later. For example, in connection with operation 401, in the embodiment of FIG. 16, the information about the mutual loss power associated with the transmission current may include information about a linear equation between the mutual loss power and the transmission current (e.g., information about the slope and intercept of the linear equation). For example, the mutual loss power and the transmission current may satisfy Equation 4 described above (e.g., a linear equation between the mutual loss power (e.g., P_{FM_M}) and the transmission current (e.g., Iₜₓ)).${{P}_{FM_M}}^{\left({est}_{¯}\right)} = {α}_{FMM} {I}_{tx}^{2} + {α}_{FMM , DC}$ (Equation 4)

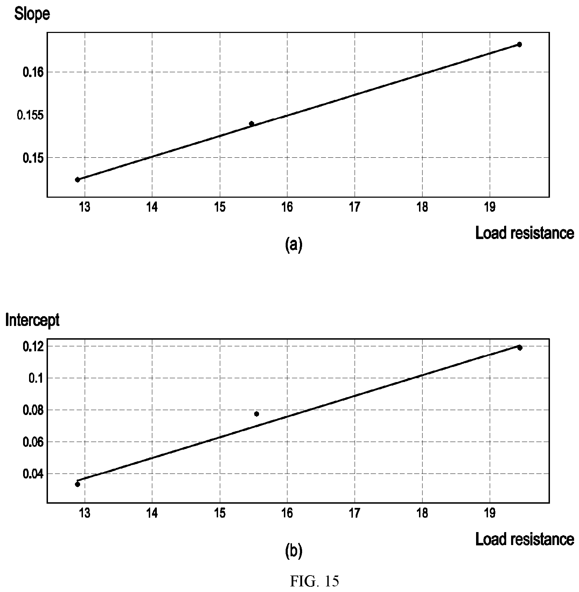

According to an embodiment, the slope and intercept of the linear equation (e.g., Equation 4) between mutual loss power and transmission current may be determined based on the load resistance of the wireless power reception device 103, which will be described with reference to FIG. 15.

In connection with operation 401, information related to the transmission current and mutual loss power (e.g., information about a linear equation, information about a matching table, or information about a value of mutual loss power) according to an embodiment may be stored in the wireless power transmission device 101. In this case, the wireless power transmission device 101 may use an identification packet (e.g., information about a terminal) received from the wireless power reception device 103 as an alternative to operation 401. For example, based on the received identification packet, the wireless power transmission device 101 may identify, among information stored in the wireless power transmission device 101, information related to the transmission current and mutual loss power (e.g., information about a linear equation, information about a matching table, or information about a value of the mutual loss power) corresponding to the wireless power reception device 103. Accordingly, the wireless power transmission device 101 may perform an operation 407 described later.

In operation 403, the wireless power transmission device 101 (e.g., the controller 215) according to an embodiment may receive second information including information related to reception current, phase difference and load resistance from the wireless power reception device 103. For example, the wireless power transmission device 101 may receive the second information according to an in-band communication method (e.g., via the transmission coil 213). For example, the wireless power transmission device 101 may receive the second information according to an out-of-band communication method (e.g., via a communication circuit). There is no limitation on a method in which the wireless power transmission device 101 receives the second information. According to an embodiment, the wireless power transmission device 101 may receive the second information during a power transmission phase. According to an embodiment, the second information may be information about a reception current (e.g., a current flowing in the reception coil 221 of the wireless power reception device 103), a phase difference (e.g., a phase difference between the reception current of the reception coil 221 and the transmission current of the transmission coil 213), and/or a load resistance of the wireless power reception device 103 (e.g., a value of the reception current, a value of the phase difference, and/or a value of the load resistance). According to an embodiment, the second information may include information related to a reception current (e.g., a current flowing in the reception coil 221 of the wireless power reception device 103), a phase difference (e.g., a phase difference between the reception current of the reception coil 221 and the transmission current of the transmission coil 213), and/or a load resistance of the wireless power reception device 103. For example, the information related to the reception current may be information of the received current, or information for calculating the received current. The information related to the phase difference may be a value of the phase difference, or may be information for calculating the phase difference. For example, the information related to the phase difference may be, but not limited to, information about a linear equation between the phase difference and the load resistance. For example, the wireless power transmission device 101 may receive information about the linear equation between the phase difference and the load resistance (e.g., information about the slope and intercept of the linear equation) during the negotiation phase. For example, the information related to the phase difference may be information about a constant phase difference for each load resistance. For example, when the load resistance falls within a specific range, the phase difference may be determined to be a specific value corresponding to the specific range. The information related to the load resistance may be the value of the load resistance, or may be information for calculating the load resistance. For example, the second information may include information about an input current of the charger 244 of the wireless power reception device 103 and an input voltage of the charger 244. The input current of the charger 244 may be an output current of the rectifier 255 of the wireless power reception device 103. The input voltage of the charger 244 may be an output voltage of the rectifier 255 of the wireless power reception device 103. The root mean square (RMS) value of the reception current of the reception coil 221 may be a constant multiple of the input current of the charger 244. The load resistance of the wireless power reception device 103 may be a ratio of the input voltage of the charger 244 to the input current of the charger 244.

In operation 405, the wireless power transmission device 101 (e.g., the controller 215) according to an embodiment may measure a transmission current (e.g., a first transmission current) of the transmission coil 213. For example, the wireless power transmission device 101 may measure the transmission current (e.g., the first transmission current) of the transmission coil 213 while transmitting power to the wireless power reception device 103.

In operation 407, the wireless power transmission device 101 (e.g., the controller 215) according to an embodiment may calculate first mutual loss power (e.g., an estimated value of the mutual loss power), based on the first information (e.g., information about the mutual loss power associated with the transmission current) of operation 401 and the first transmission current of operation 405. For example, in the embodiment of FIG. 16, the wireless power transmission device 101 may calculate the first mutual loss power (e.g., an estimated value of the mutual loss power), based on information about the linear equation (e.g., equation 4) between the mutual loss power and the transmission current (e.g., information about the slope and intercept of the linear equation). The embodiment with reference to FIG. 17 will be described later.

In operation 409, the wireless power transmission device 101 (e.g., the controller 215) according to an embodiment may calculate first loss power, based on the first mutual loss power of operation 407 and the second information of operation 403 (e.g., information related to the received current, the phase difference between the reception current and the transmission current, and the load resistance). The first loss power may be an estimated value of the total loss power. For example, the wireless power transmission device 101 may calculate the first loss power (e.g., an estimated value of the total loss power) based on Equation 1 to Equation 7. For example, the wireless power transmission device 101 may calculate a mutual current (e.g., I_{M}), based on a reception current (e.g., Iᵣₓ), a transmission current (e.g., Iₜₓ), and a phase difference (e.g., φ) between the reception current and the transmission current (e.g., Equation 3). Based on the mutual current (e.g., I_{M}) and the first mutual loss power (e.g., P_{FM_M}), the wireless power transmission device 101 may calculate a mutual resistance (e.g., R_{FM_M}) (e.g., Equation 2). The wireless power transmission device 101 may calculate first loss power, based on the mutual resistance (e.g., R_{FM_M}) (e.g., Equation 1, and Equation 4 to Equation 7).

In operation 411, the wireless power transmission device 101 (e.g., the controller 215) according to an embodiment may measure second loss power between the wireless power transmission device 101 and the wireless power reception device 103. The second loss power may be a measurement value of the total loss power. For example, the wireless power transmission device 101 may measure the second loss power between the wireless power transmission device 101 and the wireless power reception device 103, based on information received from the wireless power reception device 103 (e.g., information related to the received power of the wireless power reception device 103) while transmitting power to the wireless power reception device 103. For example, the wireless power transmission device 101 may measure the second loss power (e.g., a measurement value of the total loss power) between the wireless power transmission device 101 and the wireless power reception device 103, based on the power provided by the power source 211 of the wireless power transmission device 101, and the received power output from the rectifier 255 of the wireless power reception device 103 while transmitting power to the wireless power reception device 103. For example, the wireless power transmission device 101 may measure the difference between the transmission power provided by the wireless power transmission device 101 and the reception power received by the wireless power reception device 103 while transmitting power to the wireless power reception device 103. As used herein, the "measurement" may refer to calculating a difference between a value corresponding to the transmission power and a value corresponding to the reception power.

In operation 413, the wireless power transmission device 101 (e.g., the controller 215) according to an embodiment may identify a foreign object (e.g., the presence of a foreign object), based on a difference (e.g., P_{FM} Error = P_{FM}^{(meas)} - P_{FM}^{(est)}) between the first loss power (e.g., an estimated value of the total loss power) of operation 409 and the second loss power (e.g., a measurement value of the total loss power) of operation 411 being greater than or equal to a reference value. The wireless power transmission device 101 (e.g., the controller 215) may identify that a foreign object does not exist, based on the difference (e.g., P_{FM} Error = P_{FM}^{(meas)} - P_{FM}^{(est)}) between the first loss power (e.g., an estimated value of the total loss power) of operation 409 and the second loss power (e.g., a measurement value of the total loss power) of operation 411 being less than a reference value.

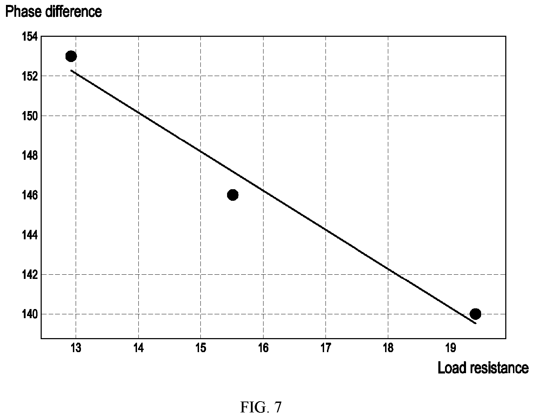

FIG. 7 illustrates the relationship between a phase difference and a load resistance according to an embodiment.

As described above, according to an embodiment, when information about a value of a phase difference between a reception current and a transmission current is transmitted from the wireless power reception device 103 to the wireless power transmission device 101, the wireless power transmission device 101 may calculate the first loss power of the operation 409 (e.g., an estimated value of the total loss power) using the value of the phase difference.

Referring to FIG. 7, according to an embodiment, when information about the relationship between the phase difference of the reception current and the transmission current and the load resistance is transmitted from the wireless power reception device 103 to the wireless power transmission device 101, the wireless power transmission device 101 may identify the phase difference based on the received information, and calculate the first loss power (e.g., an estimated value of the total loss power) of the operation 409 based on the identified phase difference. For example, as shown in FIG. 7, the phase difference (e.g., φ) and the load resistance (e.g., R_{L}) may satisfy Equation 8.$φ = {σ}_{phase} {R}_{L} + {φ}_{DC}$ (Equation 8)

According to an embodiment, the wireless power transmission device 101 may receive, from the wireless power reception device 103, information about a linear equation (e.g., Equation 8) (e.g., information about the slope and intercept) between the phase difference (e.g., φ) and the load resistance (e.g., R_{L}). For example, the wireless power transmission device 101 may receive information (e.g., information about the slope and intercept) about the linear equation (e.g., Equation 8) of the phase difference (e.g., φ) and the load resistance (e.g., R_{L}) in a negotiation phase 330 for transmitting power to the wireless power reception device 103. The wireless power transmission device 101 may identify the load resistance of the wireless power reception device 103, and calculate the phase difference based on the load resistance and the information (e.g., information about the slope and intercept) about the linear equation (e.g., Equation 8) between the phase difference (e.g., φ) and the load resistance (e.g., R_{L}).

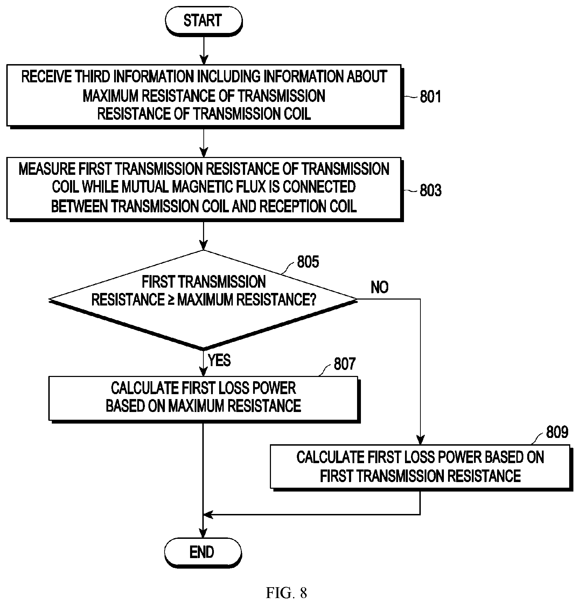

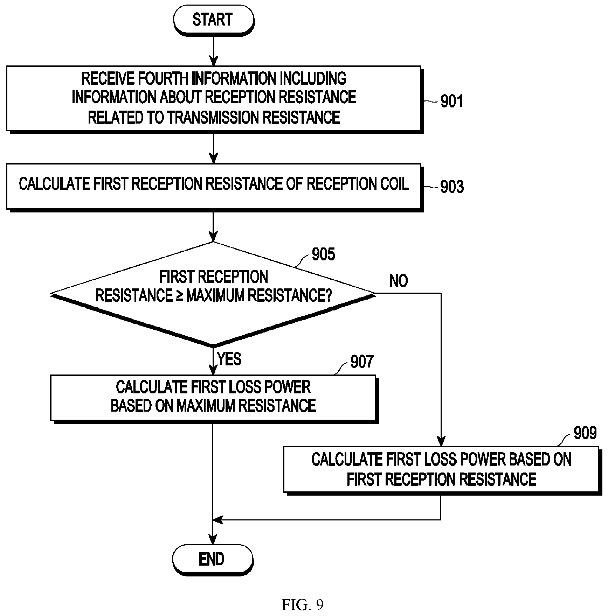

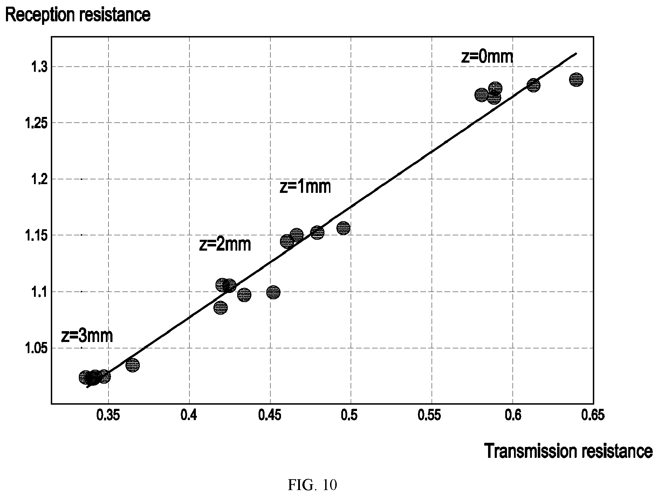

FIG. 8 is a flowchart illustrating a method of operating a wireless power transmission device related to a maximum resistance of a transmission resistance according to an embodiment. FIG. 9 is a flowchart illustrating a method of operating a wireless power transmission device related to a reception resistance according to an embodiment. FIG. 10 illustrates a relationship between a transmission resistance and a reception resistance according to an embodiment.

Referring to FIGS. 8, 9, and 10, a method of improving discrimination in foreign object detection based on an upper limit value of transmission resistance (e.g., maximum resistance) is described.

At least some of the operations of FIG. 8 may be omitted. The sequence of operations of the operations of FIG. 8 may be changed. Operations other than the operations of FIG. 8 may be performed before, during, or after performing the operations of FIG. 8.

Referring to FIG. 8, in operation 801, the wireless power transmission device 101 (e.g., the controller 215) according to an embodiment may receive third information including information about maximum resistance of transmission resistance of transmission coil from the wireless power reception device 103. For example, the wireless power transmission device 101 may receive the third information according to an in-band communication method (e.g., via the transmission coil 213). For example, the wireless power transmission device 101 may receive the third information according to an out-of-band communication method (e.g., via a communication circuit). There is no limitation on a method in which the wireless power transmission device 101 receives the third information. According to an embodiment, the wireless power transmission device 101 may receive the third information in the negotiation phase 330 for transmitting power to the wireless power reception device 103. For example, the third information may include information about a maximum resistance (e.g., an upper limit value) of the transmission resistance of the transmission coil 213. The maximum resistance (e.g., an upper limit value) of the transmission resistance of the transmission coil 213 may be a transmission resistance measured in a state in which no foreign object exists. The "state in which no foreign object exists" may be, for example, in FIG. 5, a state in which no foreign object (e.g., reference numeral 599) exists and the wireless power reception device (e.g., reference numeral 103) and the wireless power transmission device (e.g., reference numeral 101) are aligned. For example, the maximum resistance of the transmission resistance may be an upper limit value of the transmission resistance utilized in the calculation of the total loss power in Equation 1 to Equation 7. For example, the wireless power transmission device 101 may use either the maximum resistance received in operation 801 (e.g., the transmission resistance measured in the absence of foreign objects) or the transmission resistance measured in operation 803 to calculate the loss power. As described later, the wireless power transmission device 101 may calculate the loss power (e.g., operation 807 or operation 809) by comparing (e.g., operation 805) the maximum resistance received in operation 801 (e.g., the transmission resistance measured in the absence of a foreign object) with the transmission resistance measured in operation 803. By comparing the calculated loss power (e.g., operation 807 or 809) with the actual measured loss power (e.g., operation 411 of FIG. 4), the wireless power transmission device 101 may identify whether the foreign object exits (e.g., operation 413 of FIG. 4). These operations are specifically described as follows.

In operation 803, the wireless power transmission device 101 (e.g., the controller 215) according to an embodiment may measure a transmission resistance (e.g., a resistance measured in the transmission coil 213) (e.g., a first transmission resistance) while mutual magnetic flux (e.g., reference numeral 530 in FIG. 5) is connected between the transmission coil 213 and the reception coil 221.

In operation 805, the wireless power transmission device 101 (e.g., the controller 215) according to an embodiment may compare the measured transmission resistance (e.g., first transmission resistance) of operation 803 with the maximum resistance (e.g., an upper limit value) of operation 801.

In operation 807, based on the first transmission resistance of operation 803 being greater than or equal to the maximum resistance (e.g., an upper limit value) of operation 801, the wireless power transmission device 101 (e.g., the controller 215) according to an embodiment may calculate first loss power (e.g., an estimated value of the total loss power) of operation 409, based on the maximum resistance of the transmission resistance (e.g., using an upper limit value of the transmission resistance) instead of the first transmission resistance.

In operation 809, based on the first transmission resistance of operation 803 being less than the maximum resistance (e.g., an upper limit value) of operation 801, the wireless power transmission device 101 (e.g., the controller 215) according to an embodiment may calculate first loss power (e.g., an estimated value of the total loss power) of operation 409, based on the first transmission resistance of operation 803 (e.g., using a value corresponding to the first transmission resistance). In operations 807 and 809, when referring to Equation 1, Equation 5, and Equation 6, by applying a maximum resistance (e.g., an upper limit value), the P_{FM} error becomes larger in the presence of a foreign object and the P_{FM} error becomes smaller in the absence of a foreign object, thereby further increasing a reference P_{FM} error to prevent and/or reduce a foreign object detection error (e.g., a false positive foreign object detection (FOD)).

At least some of the operations of FIG. 9 may be omitted. The sequence of operations of the operations of FIG. 9 may be changed. Operations other than the operations of FIG. 9 may be performed before, during, or after performing the operations of FIG. 9.

Referring to FIG. 9, in operation 901, the wireless power transmission device 101 (e.g., the controller 215) according to an embodiment may receive fourth information including information about reception resistance related to transmission resistance from the wireless power reception device 103. For example, the wireless power transmission device 101 may receive the fourth information according to an in-band communication method (e.g., via the transmission coil 213). For example, the wireless power transmission device 101 may receive the fourth information according to an out-of-band communication method (e.g., via a communication circuit). There is no limitation on a method in which the wireless power transmission device 101 receives the fourth information. According to an embodiment, the wireless power transmission device 101 may receive the fourth information in the negotiation phase 330 for transmitting power to the wireless power reception device 103. For example, the fourth information may include information about a reception resistance of the reception coil 221 associated with a transmission resistance of the transmission coil 213. For example, the information about the reception resistance associated with the transmission resistance may be information about a linear equation (e.g., Equation 7) (e.g., information about the slope and intercept) of the transmission resistance (e.g., R'ₜₓ) and the reception resistance (e.g., R'ᵣₓ). For example, referring to FIG. 10 and Equation 7, the reception resistance (e.g., R'ᵣₓ) may be proportional to the transmission resistance (e.g., R'ₜₓ). In FIG. 10, z may be a z-axis gap due to a shielding material. Since R'ₜₓ and R'ᵣₓ decrease linearly as the z-axis gap due to the shielding material increases, the reception resistance (e.g., R'ᵣₓ^{(est)}) may be calculated according to a linear equation (e.g., Equation 7) obtained from the average resistance value for each z-axis gap.$R {′}_{rx}^{\left(est\right)} = γR {′}_{tx} + {γ}_{DC}$ (Equation 7)

In operation 903, the wireless power transmission device 101 (e.g., the controller 215) according to an embodiment may calculate a reception resistance (e.g., a first reception resistance) of the reception coil 221. For example, the wireless power transmission device 101 may calculate an estimated value (e.g., R'ᵣₓ^{(est)}) (e.g., the first reception resistance) of the reception resistance (e.g., R'ᵣₓ), based on the transmission resistance (e.g., R'ₜₓ) and Equation 7.

In operation 905, the wireless power transmission device 101 (e.g., the controller 215) according to an embodiment may compare the reception resistance (e.g., first reception resistance) calculated in operation 903 with the maximum resistance (e.g., an upper limit value) of operation 801 of FIG. 8.

According to an embodiment, referring to FIG. 17, instead of operations 901 and 903, the wireless power transmission device 101 (e.g., the controller 215) may receive information about a reception resistance of the wireless power reception device 103 (e.g., information about a value of the reception resistance) from the wireless power reception device 103. For example, the wireless power reception device 103 may calculate the reception resistance of the wireless power reception device 103 and transmit the calculated value to the wireless power transmission device 101. In this case, in operation 905, the wireless power transmission device 101 (e.g., the controller 215) may compare the information about the value of the reception resistance received from the wireless power reception device 103 with the maximum resistance (e.g., an upper limit value) of operation 801 of FIG. 8.

In operation 907, according to an embodiment, based on the first reception resistance of operation 903 being greater than or equal to the maximum resistance (e.g., an upper limit value) of operation 801 of FIG. 8, the wireless power transmission device 101 (e.g., the controller 215) may calculate first loss power (e.g., an estimated value of total loss power) of operation 409, based on the maximum resistance (e.g., using the upper limit value) instead of the first reception resistance.

In operation 909, according to an embodiment, based on the first reception resistance of operation 903 being less than the maximum resistance (e.g., an upper limit value) of operation 801 of FIG. 8, the wireless power transmission device 101 (e.g., the controller 215) may calculate first loss power (e.g., an estimated value of total loss power) of operation 409, based on the first reception resistance of operation 903 (e.g., using a value corresponding to the first reception resistance).

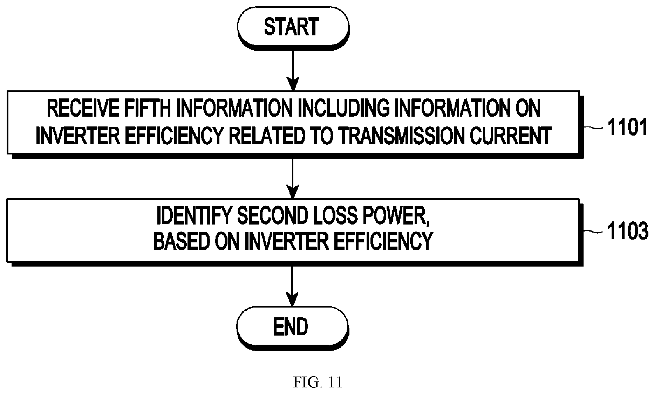

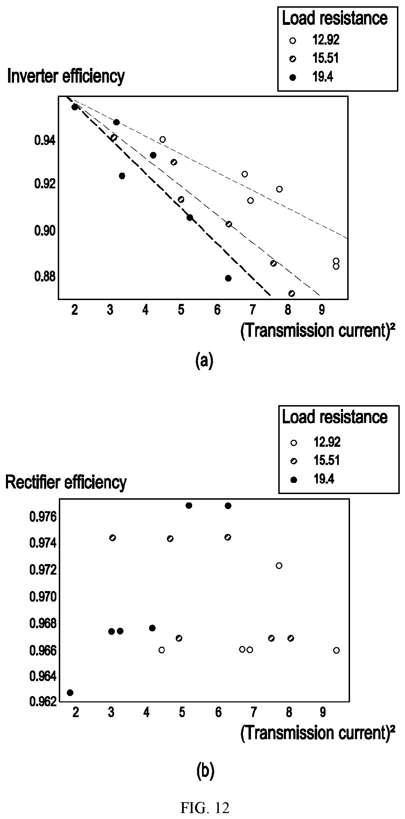

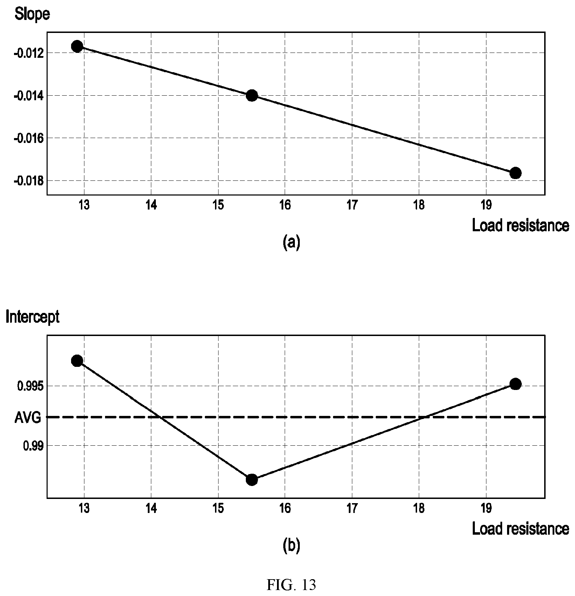

FIG. 11 is a flowchart illustrating a method of operating a wireless power transmission device related to an inverter efficiency according to an embodiment. FIG. 12 illustrates an inverter efficiency and a rectifier efficiency according to an embodiment. FIG. 13 illustrates an inverter efficiency and a load resistance according to an embodiment.

Referring to FIGS. 11, 12, and 13, a method of improving discrimination of foreign object detection based on inverter efficiency and rectifier efficiency is described.

At least some of the operations of FIG. 11 may be omitted. The operation sequence of the operations of FIG. 11 may be changed. Operations other than the operations of FIG. 11 may be performed before, during, or after performing the operations of FIG. 11.

Referring to FIG. 11, in operation 1101, the wireless power transmission device 101 (e.g., the controller 215) according to an embodiment may receive fifth information including information on inverter efficiency related to transmission current from the wireless power reception device 103. For example, the wireless power transmission device 101 may receive the fifth information according to an in-band communication method (e.g., via the transmission coil 213). For example, the wireless power transmission device 101 may receive the fifth information according to an out-of-band communication method (e.g., via a communication circuit). There is no limitation on a method in which the wireless power transmission device 101 receives the fifth information. According to an embodiment, the wireless power transmission device 101 may receive the fifth information in the negotiation phase 330 for transmitting power to the wireless power reception device 103. For example, the fifth information may include information about the inverter efficiency of the wireless power transmission device 101 associated with the transmission current. The inverter efficiency may be information about a conversion efficiency of the inverter 218 of the wireless power transmission device 101. For example, the information about the inverter efficiency associated with the transmission current may be information about a linear equation (e.g., Equation 9) (e.g., information about the slope and intercept) between the transmission current (e.g., Iₜₓ) and the inverter efficiency (e.g., ηᵢₙᵥₑᵣₜₑᵣ).${η}_{inverter} = {S}_{inv} {I}_{tx}^{2} + {η}_{inv , DC}$ (Equation 9)

Equation 9 may be understood with reference to (a) of FIG. 12 and FIG. 13. Referring to (a) of FIG. 12, depending on a load resistance, information of the linear equation (e.g., Equation 9) (e.g., information about the slope (Sᵢₙᵥ) and intercept (η_{inv,DC})) between the square of the transmission current (e.g., Iₜₓ) and the inverter efficiency (e.g., ηᵢₙᵥₑᵣₜₑᵣ) may be determined. For example, the wireless power reception device 103 may store information about the slope (Sᵢₙᵥ) and intercept (η_{inv,DC}) of a linear equation (e.g., Equation 9) for each load resistance in a state in which a foreign object does not exist. For example, the wireless power reception device 103 may identify the load resistance and, based on the load resistance, determine information about the linear equation (e.g., Equation 9) (e.g., information about the slope (Sᵢₙᵥ) and intercept (η_{inv,DC})) between the square of the transmission current (e.g., Iₜₓ) and the inverter efficiency (e.g., ηᵢₙᵥₑᵣₜₑᵣ). For example, referring to (a) of FIG. 13, the slope (Sᵢₙᵥ) of Equation 9 may have a linear relation with the load resistance. For example, referring to (b) of FIG. 12, the intercept (η_{inv,DC}) of Equation 9 may have a small variation despite changes in the load resistance. For example, the intercept (η_{inv,DC}) of Equation 9 may correspond to a constant (e.g., AVG in (b) of FIG. 13). The wireless power reception device 103 may identify the load resistance and transmit information about the linear equation (e.g., Equation 9) (e.g., information about the slope (Sᵢₙᵥ) and the intercept (η_{inv,DC})) between the transmission current (e.g., Iₜₓ) and the inverter efficiency (e.g., _{ηinverter}), determined based on the load resistance, to the wireless power transmission device 101. The wireless power transmission device 101 may receive, from the wireless power reception device 103, the information determined based on the load resistance (e.g., information about the slope (Sᵢₙᵥ) and intercept (η_{inv,DC})) of the linear equation between the transmission current (e.g., Iₜₓ) and the inverter efficiency (e.g., ηᵢₙᵥₑᵣₜₑᵣ). According to an embodiment, the wireless power transmission device 101 may receive information about the slope (Sᵢₙᵥ) and intercept (η_{inv,DC}) of the linear equation between the transmission current (e.g., Iₜₓ) and the inverter efficiency (e.g., ηᵢₙᵥₑᵣₜₑᵣ) for each load resistance in the negotiation phase 330 for transmitting power to the wireless power reception device 103. For example, the information about the slope (Sᵢₙᵥ) of the linear equation between the transmission current (e.g., Iₜₓ) and the inverter efficiency (e.g., ηᵢₙᵥₑᵣₜₑᵣ) may correspond to the information about the slope and intercept of the linear equation between the slope (Sᵢₙᵥ) and the load resistance of Equation 9 (e.g., (a) of FIG. 13). For example, since the intercept (η_{inv,DC}) of the linear equation between the transmission current (e.g., Iₜₓ) and the inverter efficiency (e.g., ηᵢₙᵥₑᵣₜₑᵣ) may have a small variation for each load resistance, the information about the intercept (η_{inv,DC}) of Equation 9 may be information about the average value (e.g., in (b) of FIG. 13).

In connection with operation 1101, for example, the fifth information may include information about a rectifier efficiency of the wireless power transportation device 101 associated with the transmission current. The rectifier efficiency may be information about a conversion efficiency of the rectifier 255 of the wireless power transportation device 101. Referring to (b) of FIG. 12, the rectifier efficiency may have a small variation despite changes in the load resistance. For example, an average value of the rectifier efficiency (e.g., η_{rectifier}) may be used. The wireless power transmission device 101 may receive information about the rectifier efficiency (e.g., ηrectifier) (e.g., information about an average value of the rectifier efficiency) from the wireless power reception device 103.

In operation 1103, the wireless power transmission device 101 (e.g., the controller 215) according to an embodiment may identify the second loss power of operation 411 of FIG. 4, based on the fifth information of operation 1101. For example, the wireless power transmission device 101 may identify the second loss power (e.g., P_{FM}^{(meas)}) of operation 411 of FIG. 4, based on the inverter efficiency (e.g., ηᵢₙᵥₑᵣₜₑᵣ) (e.g., Equation 11). For example, the wireless power transmission device 101 may identify the second loss power (e.g., P_{FM}^{(meas)}) of operation 411 of FIG. 4, based on the rectifier efficiency (e.g., η_{rectifier}) (e.g., Equation 11).${{P}_{FM}}^{\left(meas\right)} = {P}_{IN} * {η}_{inverter} \left({Itx}^{2}\right) - {P}_{OUT} / {η}_{rectifier} \left({Itx}^{2}\right) - {R}_{coil _ tx} {Itx}^{2} - {R}_{coil _ rx} {Irx}^{2}$ (Equation 11)

In Equation 11, P_{IN} may be the power provided by the power source 211 of the wireless power transmission device 101 while power is being transmitted to the wireless power reception device 103. In Equation 11, P_{OUT} may be the reception power output from the rectifier 255 of the wireless power reception device 103 while power is being transmitted to the wireless power reception device 103. R_{coil_rx}, Iₜₓ, _{Rcoil_rx}, and Iᵣₓ have been described above.

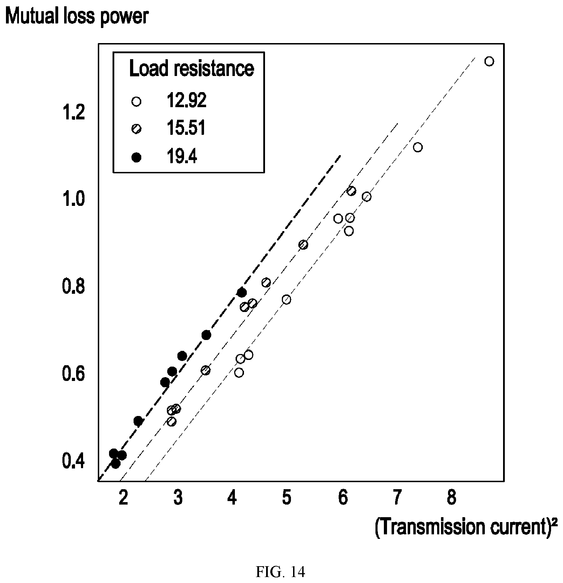

FIG. 14 illustrates mutual loss power and transmission current according to an embodiment. FIG. 15illustrates mutual loss power and a load resistance according to an embodiment.

Referring to FIG. 14 and FIG. 15, the first information of operation 401 of FIG. 4 may be described.

Referring to FIG. 14, a linear equation expression (e.g., Equation 4) between mutual loss power and transmission current may be determined based on a load resistance of the wireless power reception device 103. Referring to FIG. 15, it is illustrated as follows.

Referring to FIG. 15, the slope and intercept of the linear equation (e.g., Equation 4) between the mutual loss power and the transmission current may be determined based on the load resistance of the wireless power reception device 103. For example, as the load resistance increases, the intercept of the linear equation between the square of the transmission current and the mutual loss power may increase, as shown in FIG. 15. For example, as the load resistance increases, the slope of the linear equation between the square of the transmission current and the mutual loss power may increase in FIG. 15. According to an embodiment, the wireless power reception device 103 may identify the load resistance, and determine the slope and intercept of the linear equation (e.g., Equation 4) between the mutual loss power and the transmission current, based on the load resistance. The wireless power transmission device 101 may receive, from the wireless power reception device 103, information determined by the wireless power reception device 103 (e.g., information about the slope and intercept of the linear equation (e.g., Equation 4) between the mutual loss power and the transmission current determined based on the load resistance). According to an embodiment, the wireless power transmission device 101 may receive information about the slope and intercept of the linear equation between the square of the transmission current and the mutual loss power in the negotiation phase 330 for transmitting power to the wireless power reception device 103. For example, the information about the slope of the linear equation between the square of the transmission current and the mutual loss power may be information about the slope and intercept of the linear equation between the slope and the load resistance (e.g., (a) of FIG. 15). For example, information about the intercept of the linear equation between the square of the transmission current and the mutual loss power may be information about the slope and intercept of the linear equation between the intercept and the load resistance (e.g., (b) of FIG. 15).

FIG. 16 is a flowchart illustrating a method of operating a wireless power transmission device and a wireless power reception device according to an embodiment. FIG. 17 is a flowchart illustrating a method of operating a wireless power transmission device and a wireless power reception device according to an embodiment.

Referring to FIGS. 16, and 17, information transmitted between the wireless power transmission device 101 and the wireless power reception device 103 may be described.

The embodiments of FIGS. 4 to FIG. 15are described based on the embodiment of FIG. 16. The embodiments of FIGS. 4 to FIG. 15may also be applied to the embodiment of FIG. 17.

FIG. 16 may illustrate an embodiment in which information about the linear equation (e.g., information about the slope and intercept) is transmitted from the wireless power reception device 103 to the wireless power transmission device 101. FIG. 16 may illustrate an embodiment in which information about a matching table (e.g., information about a table in which an independent variable and a dependent variable are matched) is transmitted from the wireless power reception device 103 to the wireless power transmission device 101.

FIG. 17 may illustrate an embodiment in which information about a linear equation (e.g., information about the slope and intercept) is used, information about an independent variable is transmitted from the wireless power transmission device 101 to the wireless power reception device 103, and information about a dependent variable is transmitted from the wireless power reception device 103 to the wireless power transmission device 101. FIG. 17 may illustrate an embodiment in which information about a matching table (e.g., information about a table in which an independent variable and a dependent variable are matched) is used, information about the independent variable is transmitted from the wireless power transmission device 101 to the wireless power reception device 103, and information about the dependent variable is transmitted from the wireless power reception device 103 to the wireless power transmission device 101.

In FIGS. 16, and 17, the information about the linear equation (e.g., information about the slope and intercept) may correspond to Equation 4, Equation 7, Equation 8, or Equation 9.

Equation 4 may be a linear equation between the mutual loss power (e.g., P_{FM_M}) and the transmission current (e.g., Iₜₓ).

Equation 7 may be a linear equation between the transmission resistance (e.g., R'ₜₓ) and the reception resistance (e.g., R'ᵣₓ^{(est)}).

Equation 8 may be a linear equation between the phase difference (e.g., φ) and the load resistance (e.g., R_{L}).

Equation 9 may be a linear equation between the transmission current (e.g., Iₜₓ) and the inverter efficiency (e.g., ηᵢₙᵥₑᵣₜₑᵣ).

In FIGS. 16, and 17, the information about the matching table (e.g., information about a table in which an independent variable and a dependent variable are matched) may correspond to Equation 4, Equation 7, Equation 8, or Equation 9.

For example, in connection with Equation 4, in information about a matching table (e.g., information about a table in which an independent variable and a dependent variable are matched), the independent variable may be the transmission current (e.g., Iₜₓ) and the dependent variable may be the mutual loss power (e.g., P_{FM_M}).

For example, in connection with Equation 7, in information about a matching table (e.g., information about a table in which an independent variable and a dependent variable are matched), the independent variable may be the transmission resistance (e.g., R'ₜₓ) and the dependent variable may be the reception resistance (e.g., R'ᵣₓ^{(est)}).

For example, in connection with Equation 8, in information about a matching table (e.g., information about a table in which an independent variable and a dependent variable are matched), the independent variable may be a load resistance (e.g., R_{L}) and the dependent variable may be a phase difference (e.g., φ).

For example, in connection with Equation 9, in information about a matching table (e.g., information about a table in which an independent variable and a dependent variable are matched), the independent variable may be the transmission current (e.g., Iₜₓ) and the dependent variable may be the inverter efficiency (e.g., ηᵢₙᵥₑᵣₜₑᵣ).

Referring to FIG. 16, an embodiment related to a linear equation is described as follows.

Referring to FIG. 16, in operation 1601, the wireless power reception device 103 (e.g., the controller 250) according to an embodiment may store information about the linear equation (e.g., information about the slope and intercept).

In operation 1603, the wireless power reception device 103 (e.g., the controller 250) according to an embodiment may transmit information about the linear equation (e.g., information about the slope and intercept) to the wireless power transmission device 101. The wireless power transmission device 101 (e.g., the controller 215) may receive the information about the linear equation (e.g., information about the slope and intercept) from the wireless power reception device 103.

In operation 1605, the wireless power transmission device 101 (e.g., the controller 215) according to an embodiment may identify independent variables (e.g., a transmission current (e.g., Iₜₓ), a transmission resistance (e.g., R'ₜₓ), and/or a load resistance (e.g., R_{L})).

In operation 1607, the wireless power transmission device 101 (e.g., the controller 215) according to an embodiment may calculate dependent variables (e.g., mutual loss power (e.g., P_{FM_M}), a reception resistance (e.g., R'ᵣₓ^{(est)}), a phase difference (e.g., φ), and/or an inverter efficiency (e.g., ηᵢₙᵥₑᵣₜₑᵣ)), based on the information about the linear equation of operation 1603.

Referring to FIG. 16, an embodiment related to a matching table is described as follows.

Referring to FIG. 16, in operation 1601, the wireless power reception device 103 (e.g., the controller 250) according to an embodiment may store information about a matching table (e.g., information about a table in which an independent variable and a dependent variable are matched).

In operation 1603, the wireless power reception device 103 (e.g., the controller 250) according to an embodiment may transmit information about a matching table (e.g., information about a table in which an independent variable and a dependent variable are matched) to the wireless power transmission device 101. The wireless power transmission device 101 (e.g., the controller 215) may receive the information about the matching table (e.g., information about the table in which the independent variable and the dependent variable are matched) from the wireless power reception device 103.

In operation 1605, the wireless power transmission device 101 (e.g., the controller 215) according to an embodiment may identify independent variables (e.g., a transmission current (e.g., Iₜₓ), a transmission resistance (e.g., R'ₜₓ), and/or a load resistance (e.g., R_{L})).

In operation 1607, the wireless power transmission device 101 (e.g., the controller 215) according to an embodiment may identify dependent variables (e.g., mutual loss power (e.g., P_{FM_M}), a reception resistance (e.g., R'ᵣₓ^{(est)}), a phase difference (e.g., φ), and/or an inverter efficiency (e.g., ηᵢₙᵥₑᵣₜₑᵣ)), based on the information about the matching table of operation 1603.

An embodiment related to a linear equation expression is described with reference to FIG. 17.

Referring to FIG. 17, in operation 1701, the wireless power reception device 103 (e.g., the controller 250) according to an embodiment may store information about the linear equation (e.g., information about the slope and intercept).

In operation 1703, the wireless power reception device 103 (e.g., the controller 250) according to an embodiment may receive information about independent variables (e.g., a transmission current (e.g., Iₜₓ), a transmission resistance (e.g., R'ₜₓ), and/or a load resistance (e.g., R_{L})) from the wireless power transmission device 101. The wireless power transmission device 101 (e.g., the controller 215) may transmit information about the independent variables (e.g., the transmission current (e.g., Iₜₓ), the transmission resistance (e.g., R'ₜₓ), and/or the load resistance (e.g., R_{L})) to the wireless power reception device 103.

In operation 1705, according to an embodiment, based on the information about the linear equation of operation 1701 and the information about the independent variables (e.g., the transmission current (e.g., Iₜₓ), the transmission resistance (e.g., R'ₜₓ), and/or the load resistance (e.g., R_{L})) of operation 1703, the wireless power reception device 103 (e.g., the controller 250) may calculate the dependent variables (e.g., mutual loss power (e.g., P_{FM_M}), a reception resistance (e.g., R'ᵣₓ^{(est)}), a phase difference (e.g., φ), and/or an inverter efficiency (e.g., ηᵢₙᵥₑᵣₜₑᵣ)).

In operation 1707, the wireless power reception device 103 (e.g., the controller 250) according to an embodiment may transmit information about the dependent variables (e.g., the mutual loss power (e.g., P_{FM_M}), the reception resistance (e.g., R'ᵣₓ^{(est)}), the phase difference (e.g., φ), and/or the inverter efficiency (e.g., ηᵢₙᵥₑᵣₜₑᵣ)) to the wireless power transmission device 101. The wireless power transmission device 101 (e.g., the controller 215) may receive the information about the dependent variables (e.g., the mutual loss power (e.g., P_{FM_M}), the reception resistance (e.g., R'ᵣₓ^{(est)}), the phase difference (e.g., φ), and/or the inverter efficiency (e.g., ηᵢₙᵥₑᵣₜₑᵣ)) from the wireless power reception device 103.

With reference to FIG. 17, an embodiment related to a matching table is described as follows.

Referring to FIG. 17, in operation 1701, the wireless power reception device 103 (e.g., the controller 250) according to an embodiment may store information about a matching table (e.g., information about a table in which an independent variable and a dependent variable are matched).

In operation 1703, the wireless power reception device 103 (e.g., the controller 50) according to an embodiment may receive information about independent variables (e.g., a transmission current (e.g., Iₜₓ), a transmission resistance (e.g., R'ₜₓ), and/or a load resistance (e.g., R_{L})) from the wireless power transmission device 101. The wireless power transmission device 101 (e.g., the controller 215) may transmit information about the independent variables (e.g., the transmission current (e.g., Iₜₓ), the transmission resistance (e.g., R'ₜₓ), and/or the load resistance (e.g., R_{L})) to the wireless power reception device 103.

In operation 1705, according to an embodiment, based on the information about the matching table of operation 1701 and the information about the independent variables (e.g., the transmission current (e.g., Iₜₓ), the transmission resistance (e.g., R'ₜₓ), and/or the load resistance (e.g., R_{L})) of operation 1703, the wireless power reception device 103 (e.g., the controller 250) may identify dependent variables (e.g., mutual loss power (e.g., P_{FM_M}), a reception resistance (e.g., R'ᵣₓ^{(est)}), a phase difference (e.g., φ), and/or an inverter efficiency (e.g., ηᵢₙᵥₑᵣₜₑᵣ)).

In operation 1707, the wireless power reception device 103 (e.g., the controller 250) according to an embodiment may transmit information about the dependent variables (e.g., the mutual loss power (e.g., P_{FM_M}), the reception resistance (e.g., R'ᵣₓ^{(est)}), the phase difference (e.g., φ), and/or the inverter efficiency (e.g., ηᵢₙᵥₑᵣₜₑᵣ)) to the wireless power transmission device 101. The wireless power transmission device 101 (e.g., the controller 215) may receive the information about the dependent variables (e.g., the mutual loss power (e.g., P_{FM_M}), the reception resistance (e.g., R'ᵣₓ^{(est)}), the phase difference (e.g., φ), and/or the inverter efficiency (e.g., ηᵢₙᵥₑᵣₜₑᵣ)) from the wireless power reception device 103.

It will be understood by those skilled in the art that the embodiments described herein may be applied interchangeably within the scope of their applicability. For example, those skilled in the art will understand that at least some of the operations of an embodiment described herein may be applied while being omitted, and at least some of the operations according to an embodiment may be combined and applied.

The technical task to be achieved in this document is not limited to the technical task mentioned above, and other technical tasks not mentioned can be clearly understood by those with ordinary knowledge in the technical field to which this document belongs from the description below.

The effects that can be obtained from this disclosure are not limited to the effects mentioned above, and other effects not mentioned can be clearly understood by those with ordinary knowledge in the technical field to which this disclosure belongs from the description below.

According to an embodiment, a wireless power transmission device 101 may include a transmission coil 213, at least one controller 215 comprising processing circuitry, and memory 210 storing instructions. The instructions, when executed by the at least one controller 215, may cause the wireless power transmission device 101 to receive first information from a wireless power reception device 103. The first information may include information related to a transmission current of the transmission coil 213 and mutual loss power. The instructions, when executed by the at least one controller 215, may cause the wireless power transmission device 101 to receive second information from the wireless power reception device 103. The second information may include information related to a reception current of a reception coil 221 of the wireless power reception device 103, a phase difference between the reception current and the transmission current, and/or a load resistance of the wireless power reception device 103. The instructions, when executed by the at least one controller 215, may cause the wireless power transmission device 101 to measure a first transmission current of the transmission coil 213. The instructions, when executed by the at least one controller 215, may cause the wireless power transmission device 101 to calculate first mutual loss power, based on the first information and the first transmission current. The instructions, when executed by the at least one controller 215, may cause the wireless power transmission device 101 to calculate first loss power, based on the first mutual loss power and the second information. The first loss power may be loss power generated by magnetic flux of the transmission coil 213, magnetic flux of the reception coil 221, and/or mutual magnetic flux connected between the transmission coil 213 and the reception coil 221. The instructions, when executed by the at least one controller 215, may cause the wireless power transmission device 101 to measure second loss power between the wireless power transmission device 101 and the wireless power reception device 103. The instructions, when executed by the at least one controller 215, may cause the wireless power transmission device 101 to identify a foreign object, based on a difference between the first loss power and the second loss power being greater than or equal to a reference value.

According to an embodiment, in the wireless power transmission device 101, the first loss power may include loss power generated in the friendly metal by the magnetic flux of the transmission coil 213, the magnetic flux of the reception coil 221, and/or the mutual magnetic flux.

According to an embodiment, in the wireless power transmission device 101, the friendly metal may include a first friendly metal of the wireless power reception device 103, a second friendly metal of the wireless power transmission device, the transmission coil 213, and/or the reception coil 221.

According to an embodiment, in the wireless power transmission device 101, the first information may be received through the transmission coil 213. The second information may be received through the transmission coil 213.

According to an embodiment, in the wireless power transmission device 101, the instructions, when executed by the at least one controller 215, cause the wireless power transmission device 101 to receive the first information in a negotiation phase for transmitting power to the wireless power reception device 103. The instructions, when executed by the at least one controller 215, cause the wireless power transmission device 101 to receive the second information in a power transfer phase to the wireless power reception device 103.

According to an embodiment, in the wireless power transmission device 101, the first information may include information about a slope and an intercept of a linear equation between the mutual loss power and the transmission current.

According to an embodiment, in the wireless power transmission device 101, the instructions, when executed by the at least one controller 215, cause the wireless power transmission device 101 to calculate a mutual current, based on the reception current, the transmission current, and the phase difference between the reception current and the transmission current. The instructions, when executed by the at least one controller 215, cause the wireless power transmission device 101 to calculate a mutual resistance, based on the mutual current and the mutual loss power. The instructions, when executed by the at least one controller 215, cause the wireless power transmission device 101 to calculate the first loss power, based on the mutual resistance.

According to an embodiment, in the wireless power transmission device 101, the instructions, when executed by the at least one controller 215, cause the wireless power transmission device 101 to receive third information from the wireless power reception device 103 through the transmission coil 213. The third information may include information about a maximum resistance of a transmission resistance of the transmission coil 213. The instructions, when executed by the at least one controller 215, cause the wireless power transmission device 101 to measure a first transmission resistance of the transmission coil 213 while the mutual magnetic flux is connected between the transmission coil 213 and the reception coil 221. The instructions, when executed by the at least one controller 215, cause the wireless power transmission device 101 to calculate the first loss power based on the maximum resistance, based on the first transmission resistance being greater than or equal to the maximum resistance. The instructions, when executed by the at least one controller 215, cause the wireless power transmission device 101 to calculate the first loss power based on the first transmission resistance, based on the first transmission resistance being less than the maximum resistance.

According to an embodiment, in the wireless power transmission device 101, the instructions, when executed by the at least one controller 215, cause the wireless power transmission device 101 to receive fourth information from the wireless power reception device 103 through the transmission coil 213. The fourth information may include information about a reception resistance of the reception coil 221 related to the transmission resistance of the transmission coil 213. The instructions, when executed by the at least one controller 215, cause the wireless power transmission device 101 to calculate a first reception resistance of the reception coil 221, based on the fourth information and the first transmission resistance. The instructions, when executed by the at least one controller 215, cause the wireless power transmission device 101 to calculate the first loss power based on the maximum resistance, based on the first reception resistance being greater than or equal to the maximum resistance. The instructions, when executed by the at least one controller 215, cause the wireless power transmission device 101 to calculate the first loss power based on the first reception resistance, based on the first reception resistance being less than the maximum resistance.

According to an embodiment, in the wireless power transmission device 101, the instructions, when executed by the at least one controller 215, cause the wireless power transmission device 101 to receive fifth information from the wireless power reception device 103 through the transmission coil 213. The fifth information may include information about inverter efficiency of the wireless power transmission device 101 related to the transmission current. The instructions, when executed by the at least one controller 215, cause the wireless power transmission device 101 to identify the second loss power, based on the inverter efficiency.

According to an embodiment, in the wireless power transmission device 101, the fifth information may include information about a slope and an intercept of a linear equation between the inverter efficiency and the transmission current. The slope of the linear equation between the inverter efficiency and the transmission current may be determined by the wireless power reception device 103, based on the load resistance of the wireless power reception device 103.

According to an embodiment, in the wireless power transmission device 101, the second information may include information about an input current of a charger of the wireless power reception device 103 and an input voltage of the charger.

According to an embodiment, in the wireless power transmission device 101, the slope of the linear equation between the mutual loss power and the transmission current may be determined by the wireless power reception device 103, based on the load resistance of the wireless power reception device 103.

According to an embodiment, a method of operating the wireless power transmission device 101 may include receiving first information from a wireless power reception device 103. The first information may include information related to a transmission current of a transmission coil 213 of the wireless power transmission device 101 and mutual loss power. The method may include receiving second information from the wireless power reception device 103. The second information may include information related to a reception current of a reception coil 221 of the wireless power reception device 103, a phase difference between the reception current and the transmission current, and/or a load resistance of the wireless power reception device 103. The method may include measuring a first transmission current of the transmission coil 213. The method may include calculating, based on the first information and the first transmission current, first mutual loss power. The method may include calculating, based on the first mutual loss power and the second information, first loss power. The first loss power may be loss power caused by magnetic flux of the transmission coil 213, magnetic flux of the reception coil 221, and mutual magnetic flux connected between the transmission coil 213 and the reception coil 221. The method may include measuring second loss power between the wireless power transmission device 101 and the wireless power reception device 103. The method may include identifying a foreign object, based on a difference between the first loss power and the second loss power being greater than or equal to a reference value.

According to an embodiment, in the method of operating the wireless power transmission device 101, the first loss power may include loss power generated in the friendly metal by the magnetic flux of the transmission coil 213, the magnetic flux of the reception coil 221, and/or the mutual magnetic flux.

According to an embodiment, in the method of operating the wireless power transmission device 101, the friendly metal may include a first friendly metal of the wireless power reception device 103, a second friendly metal of the wireless power transmission device, the transmission coil 213, and/or the reception coil 221.

According to an embodiment, in the method of operating the wireless power transmission device 101, the first information may be received through the transmission coil 213. The second information may be received through the transmission coil 213.

According to an embodiment, the method of operating the wireless power transmission device 101 may include receiving the first information in a negotiation phase for transmitting power to the wireless power reception device 103. The method may include receiving the second information in a power transfer phase to the wireless power reception device 103.

According to an embodiment, in the method of operating the wireless power transmission device 101, the first information may include information about a slope and an intercept of a linear equation between the mutual loss power and the transmission current.

According to an embodiment, the method of operating the wireless power transmission device 101 may include calculating a mutual current, based on the reception current, the transmission current, and the phase difference between the reception current and the transmission current. The method may include calculating a mutual resistance, based on the mutual current and the mutual loss power. The method may include calculating the first loss power, based on the mutual resistance.

According to an embodiment, the method of operating the wireless power transmission device 101 may include receiving third information from the wireless power reception device 103 through the transmission coil 213. The third information may include information about a maximum resistance of a transmission resistance of the transmission coil 213. The method may include measuring a first transmission resistance of the transmission coil 213 while the mutual magnetic flux is connected between the transmission coil 213 and the reception coil 221. The method may include calculating the first loss power based on the maximum resistance, based on the first transmission resistance being greater than or equal to the maximum resistance. The method may include calculating the first loss power based on the first transmission resistance, based on the first transmission resistance being less than the maximum resistance.

According to an embodiment, the method of operating the wireless power transmission device 101 may include receiving fourth information from the wireless power reception device 103 through the transmission coil 213. The fourth information may include information about a reception resistance of the reception coil 221 related to the transmission resistance of the transmission coil 213. The method may include calculating a first reception resistance of the reception coil 221, based on the fourth information and the first transmission resistance. The method may include calculating the first loss power based on the maximum resistance, based on the first reception resistance being greater than or equal to the maximum resistance. The method may include calculating the first loss power based on the first reception resistance, based on the first reception resistance being less than the maximum resistance.

According to an embodiment, the method of operating the wireless power transmission device 101 may include receiving fifth information from the wireless power reception device 103 through the transmission coil 213. The fifth information may include information about inverter efficiency of the wireless power transmission device 101 related to the transmission current. The method may include identifying the second loss power, based on the inverter efficiency.

According to an embodiment, in the method of operating the wireless power transmission device 101, the fifth information may include information about a slope and an intercept of a linear equation between the inverter efficiency and the transmission current. The slope of the linear equation between the inverter efficiency and the transmission current may be determined by the wireless power reception device 103, based on the load resistance of the wireless power reception device 103.

According to an embodiment, in the method of operating the wireless power transmission device 101, the second information may include information about an input current of a charger of the wireless power reception device 103 and an input voltage of the charger.

According to an embodiment, in the method of operating the wireless power transmission device 101, the slope of the linear equation between the mutual loss power and the transmission current may be determined by the wireless power reception device 103, based on the load resistance of the wireless power reception device 103.

According to an embodiment, there may be provided a non-transitory computer-readable storage medium storing at least one instruction, wherein the at least one instruction, when executed by at least one controller 215, comprising processing circuitry, of the wireless power transmission device 101, causes the wireless power transmission device 101 to perform at least one operation. The at least one operation may include receiving first information from the wireless power reception device 103. The first information may include information related to a transmission current of the transmission coil 213 of the wireless power transmission device 101 and mutual loss power. The at least one operation may include receiving second information from the wireless power reception device 103. The second information may include information related to a reception current of a reception coil 221 of the wireless power reception device 103, a phase difference between the reception current and the transmission current, and/or a load resistance of the wireless power reception device 103. The at least one operation may include measuring a first transmission current of the transmission coil 213. The at least one operation may include calculating first mutual loss power, based on the first information and the first transmission current. The at least one operation may include calculating first loss power, based on the first mutual loss power and the second information. The first loss power may be loss power caused by magnetic flux of the transmission coil 213, magnetic flux of the reception coil 221, and mutual magnetic flux connected between the transmission coil 213 and the reception coil 221. The at least one operation may include measuring second loss power between the wireless power transmission device 101 and the wireless power reception device 103. The at least one operation may include identifying a foreign object, based on a difference between the first loss power and the second loss power being greater than or equal to a reference value.

According to an embodiment, in the non-transitory computer-readable storage medium, the first loss power may include loss power generated in the friendly metal by the magnetic flux of the transmission coil 213, the magnetic flux of the reception coil 221, and/or the mutual magnetic flux.

According to an embodiment, in the non-transitory computer-readable storage medium, the friendly metal may include a first friendly metal of the wireless power reception device 103, a second friendly metal of the wireless power transmission device 101, the transmission coil 213, and/or the reception coil 221.

According to an embodiment, in the non-transitory computer-readable storage medium, the first information may be received through the transmission coil 213. The second information may be received through the transmission coil 213.

According to an embodiment, in the non-transitory computer-readable storage medium, the at least one operation may include receiving the first information in a negotiation phase for transmitting power to the wireless power reception device 103. The at least one operation may include receiving the second information in a power transfer phase to the wireless power reception device 103.

According to an embodiment, in the non-transitory computer-readable storage medium, the first information may include information about a slope and an intercept of a linear equation between the mutual loss power and the transmission current.

According to an embodiment, in the non-transitory computer-readable storage medium, the at least one operation may include calculating a mutual current, based on the reception current, the transmission current, and the phase difference between the reception current and the transmission current. The at least one operation may include calculating a mutual resistance, based on the mutual current and the mutual loss power. The at least one operation may include calculating the first loss power, based on the mutual resistance.

According to an embodiment, in the non-transitory computer-readable storage medium, the at least one operation may include receiving third information from the wireless power reception device 103 through the transmission coil 213. The third information may include information about a maximum resistance of a transmission resistance of the transmission coil 213. The at least one operation may include measuring a first transmission resistance of the transmission coil 213 while the mutual magnetic flux is connected between the transmission coil 213 and the reception coil 221. The at least one operation may include calculating the first loss power based on the maximum resistance, based on the first transmission resistance being greater than or equal to the maximum resistance. The at least one operation may include calculating the first loss power based on the first transmission resistance, based on the first transmission resistance being less than the maximum resistance.

According to an embodiment, in the non-transitory computer-readable storage medium, the at least one operation may include receiving fourth information from the wireless power reception device 103 through the transmission coil 213. The fourth information may include information about a reception resistance of the reception coil 221 related to the transmission resistance of the transmission coil 213. The at least one operation may include calculating a first reception resistance of the reception coil 221, based on the fourth information and the first transmission resistance. The at least one operation may include calculating the first loss power based on the maximum resistance, based on the first reception resistance being greater than or equal to the maximum resistance. The at least one operation may include calculating the first loss power based on the first reception resistance, based on the first reception resistance being less than the maximum resistance.

According to an embodiment, in the non-transitory computer-readable storage medium, the at least one operation may include receiving fifth information from the wireless power reception device 103 through the transmission coil 213. The fifth information may include information about inverter efficiency of the wireless power transmission device 101 related to the transmission current. The at least one operation may include identifying the second loss power, based on the inverter efficiency.

According to an embodiment, in the non-transitory computer-readable storage medium, the fifth information may include information about a slope and an intercept of a linear equation between the inverter efficiency and the transmission current. The slope of the linear equation between the inverter efficiency and the transmission current may be determined by the wireless power reception device 103, based on the load resistance of the wireless power reception device 103.

According to an embodiment, in the non-transitory computer-readable storage medium, the second information may include information about an input current of a charger of the wireless power reception device 103 and an input voltage of the charger.

According to an embodiment, in the non-transitory computer-readable storage medium, the slope of the linear equation between the mutual loss power and the transmission current may be determined by the wireless power reception device 103, based on the load resistance of the wireless power reception device 103.

According to an embodiment, a wireless power transmission device 101 may include a transmission coil 213, at least one controller 215, comprising processing circuitry, and memory 210 storing instructions. The instructions, when executed by the at least one controller 215, may cause the wireless power transmission device 101 to receive first information from a wireless power reception device 103. The first information may include information relating to an amount of electrical power applied to the transmission coil 213 for providing wireless charging power in relation to an amount of mutual loss power caused by friendly metal interfering with mutual magnetic flux. The mutual magnetic flux may include magnetic flux connected between the transmission coil 213 and a reception coil 221 of the wireless power reception device 103. The instructions, when executed by the at least one controller 215, may cause the wireless power transmission device 101 to, while providing wireless charging power through the transmission coil 213, identify second information relating to a first transmission current being applied to the transmission coil 213. The instructions, when executed by the at least one controller 215, may cause the wireless power transmission device 101 to identify third information relating to first loss power incurred while providing wireless charging power from the wireless power transmission device 101 to the wireless power reception device 103. The instructions, when executed by the at least one controller 215, may cause the wireless power transmission device 101 to, while providing wireless charging power through the transmission coil 213, detect a foreign metal object, based on the first information, the second information, and the third information.

According to an embodiment, in the wireless power transmission device 101, the instructions, when executed by the at least one controller 215, cause the wireless power transmission device 101 to calculate first mutual loss power, based on the first information and the second information. The instructions, when executed by the at least one controller 215, may cause the wireless power transmission device 101 to calculate second loss power, based on the first mutual loss power. The second loss power may include loss power generated by magnetic flux of the transmission coil 213, magnetic flux of the reception coil 221, and/or the mutual magnetic flux. The instructions, when executed by the at least one controller 215, may cause the wireless power transmission device 101 to detect the foreign metal object, based on a difference between the first loss power and the second loss power being greater than or equal to a reference value.

According to an embodiment, in the wireless power transmission device 101, the instructions, when executed by the at least one controller 215, cause the wireless power transmission device 101 to receive fourth information from the wireless power reception device 103. The fourth information may include information related to a reception current of the reception coil 221, a phase difference between the reception current and a transmission current of the transmission coil 213, and/or a load resistance of the wireless power reception device 103. The instructions, when executed by the at least one controller 215, cause the wireless power transmission device 101 to calculate second loss power, based on the first mutual loss power and the fourth information.

According to an embodiment, in the wireless power transmission device 101, the first information may include information about a slope and an intercept of a linear equation between the mutual loss power and the power applied to the transmission coil 213. The first information may include information about a matching table between values corresponding to the mutual loss power and values corresponding to the power applied to the transmission coil 213.

According to an embodiment, in the wireless power transmission device 101, in the first information, the power applied to the transmission coil 213 may include one of a transmission current applied to the transmission coil 213, transmission power applied to the transmission coil 213, output power of an inverter 218 electrically connected to the transmission coil 213, or input power of the inverter 218.

The device according to various embodiments set forth herein may be one of various types of electronic devices. The device may include, for example, a portable communication device (e.g., a smart phone), a computer device, a portable multimedia device, a portable medical device, a camera, a wearable device, or a home appliance. The device according to embodiments of the disclosure is not limited to those described above.

It should be appreciated that the embodiments and the terms used therein are not intended to limit the technological features set forth herein to particular embodiments and the disclosure includes various changes, equivalents, or alternatives for a corresponding embodiment. With regard to the description of the drawings, similar reference numerals may be used to designate similar or relevant elements. A singular form of a noun corresponding to an item may include one or more of the items, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one or all possible combinations of the items enumerated together in a corresponding one of the phrases. Such terms as "a first," "a second," "the first," and "the second" may be used to simply distinguish a corresponding element from another, and does not limit the elements in other aspect (e.g., importance or order). If an element (e.g., a first element) is referred to, with or without the term "operatively" or "communicatively", as "coupled with/to" or "connected with/to" another element (e.g., a second element), it means that the element may be coupled/connected with/to the other element directly (e.g., wiredly), wirelessly, or via a third element.

As used in various embodiments of the disclosure, the term "module" may include a unit implemented in hardware, software, or firmware, and may be interchangeably used with other terms, for example, "logic," "logic block," "component," or "circuit". The "module" may be a single integrated component, or a minimum unit or part thereof, adapted to perform one or more functions. For example, according to an embodiment, the "module" may be implemented in the form of an application-specific integrated circuit (ASIC).

Various embodiments as set forth herein may be implemented as software (e.g., a program) including one or more instructions that are stored in a storage medium that is readable by a machine (e.g., an electronic device). For example, a processor (e.g., a controller) of the machine may invoke at least one of the one or more stored instructions from the storage medium, and execute it. This allows the machine to be operated to perform at least one function according to the at least one instruction invoked. The one or more instructions each may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, methods according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., Play Store^{TM}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each element (e.g., a module or a program) of the above-described elements may include a single entity or multiple entities, and some of the multiple entities may be separately disposed in another element. According to various embodiments, one or more of the above-described elements or operations may be omitted, or one or more other elements or operations may be added. Alternatively or additionally, a plurality of elements (e.g., modules or programs) may be integrated into a single element. In such a case, according to various embodiments, the integrated element may still perform one or more functions of each of the plurality of elements in the same or similar manner as they are performed by a corresponding one of the plurality of elements before the integration. According to various embodiments, operations performed by the module, the program, or another element may be carried out sequentially, in parallel, repeatedly, or heuristically, or one or more of the operations may be executed in a different order or omitted, or one or more other operations may be added.

While the disclosure has been illustrated and described with reference to various example embodiments, it will be understood that the various example embodiments are intended to be illustrative, not limiting. It will be further understood by those skilled in the art that various changes in form and detail may be made without departing from the true spirit and full scope of the disclosure, including the appended claims and their equivalents. It will also be understood that any of the embodiment(s) described herein may be used in conjunction with any other embodiment(s) described herein.

## Claims

1. A wireless power transmission device (101) comprising:
a transmission coil (213);
at least one controller (215) comprising processing circuitry; and
memory (210) storing instructions that, when executed by the at least one controller (215), cause the wireless power transmission device (101) to:
receive first information from a wireless power reception device (103), wherein the first information includes information related to a transmission current of the transmission coil (213) and mutual loss power,
receive second information from the wireless power reception device (103), wherein the second information includes information related to a reception current of a reception coil (221) of the wireless power reception device (103), a phase difference between the reception current and the transmission current, and/or a load resistance of the wireless power reception device (103),
measure a first transmission current of the transmission coil (213),
calculate first mutual loss power, based on the first information and the first transmission current,
calculate first loss power, based on the first mutual loss power and the second information, wherein the first loss power is loss power generated by magnetic flux of the transmission coil (213), magnetic flux of the reception coil (221), and/or mutual magnetic flux connected between the transmission coil (213) and the reception coil (221),
measure second loss power between the wireless power transmission device (101) and the wireless power reception device (103), and
identify a foreign object, based on a difference between the first loss power and the second loss power being greater than or equal to a reference value.

2. The wireless power transmission device (101) of claim 1, wherein:
the first loss power includes loss power generated in friendly metal by the magnetic flux of the transmission coil (213), the magnetic flux of the reception coil (221), and/or the mutual magnetic flux.

3. The wireless power transmission device (101) of claim 1 or 2, wherein the friendly metal includes a first friendly metal of the wireless power reception device (103), a second friendly metal of the wireless power transmission device (101), the transmission coil (213), and/or the reception coil (221).

4. The wireless power transmission device (101) of any one of claims 1 to 3, wherein the first information is received through the transmission coil (213), and the second information is received through the transmission coil (213).

5. The wireless power transmission device (101) of any one of claims 1 to 4, wherein the instructions, when executed by the at least one controller (215), cause the wireless power transmission device (101) to:
receive the first information in a negotiation step for transmitting power to the wireless power reception device (103), and
receive the second information in a power transfer step to the wireless power reception device (103).

6. The wireless power transmission device (101) of any one of claims 1 to 5, wherein the first information includes information about a slope and an intercept of a linear equation between the mutual loss power and the transmission current.

7. The wireless power transmission device (101) of any one of claims 1 to 6, wherein the instructions, when executed by the at least one controller (215), cause the wireless power transmission device (101) to:
calculate a mutual current, based on the reception current, the transmission current and the phase difference between the reception current and the transmission current;
calculate a mutual resistance, based on the mutual current and the mutual loss power; and
calculate the first loss power, based on the mutual resistance.

8. The wireless power transmission device (101) of any one of claims 1 to 7, wherein the instructions, when executed by the at least one controller (215), cause the wireless power transmission device (101) to:
receive third information from the wireless power reception device (103) through the transmission coil (213), wherein the third information includes information about a maximum resistance of a transmission resistance of the transmission coil (213),
measure a first transmission resistance of the transmission coil (213) while the mutual magnetic flux is connected between the transmission coil (213) and the reception coil (221),
calculate the first loss power based on the maximum resistance, based on the first transmission resistance being greater than or equal to the maximum resistance, and
calculate the first loss power based on the first transmission resistance, based on the first transmission resistance being less than the maximum resistance.

9. The wireless power transmission device (101) of any one of claims 1 to 8, wherein the instructions, when executed by the at least one controller (215), cause the wireless power transmission device (101) to:
receive fourth information from the wireless power reception device (103) through the transmission coil (213), wherein the fourth information includes information about a reception resistance of the reception coil (221) related to the transmission resistance of the transmission coil (213),
calculate a first reception resistance of the reception coil (221), based on the fourth information and the first transmission resistance,
calculate the first loss power based on the maximum resistance, based on the first reception resistance being greater than or equal to the maximum resistance, and
calculate the first loss power based on the first reception resistance, based on the first reception resistance being less than the maximum resistance.

10. The wireless power transmission device (101) of any one of claims 1 to 9, wherein the instructions, when executed by the at least one controller (215), cause the wireless power transmission device (101) to:
receive fifth information from the wireless power reception device (103) through the transmission coil (213), wherein the fifth information includes information about inverter efficiency of the wireless power transmission device (101) related to the transmission current, and
identify the second loss power, based on the inverter efficiency.

11. The wireless power transmission device (101) of any one of claims 1 to 10, wherein the fifth information includes information about a slope and an intercept of a linear equation between the inverter efficiency and the transmission current, and
wherein the slope of the linear equation between the inverter efficiency and the transmission current is determined by the wireless power reception device (103) based on the load resistance of the wireless power reception device (103).

12. The wireless power transmission device (101) of any one of claims 1 to 11, wherein the second information includes information about an input current of a charger of the wireless power reception device (103) and an input voltage of the charger.

13. The wireless power transmission device (101) of any one of claims 1 to 12, wherein the slope of the linear equation between the mutual loss power and the transmission current is determined by the wireless power reception device (103) based on the load resistance of the wireless power reception device (103).

14. A method of operating a wireless power transmission device (101), the method comprising:
receiving first information from a wireless power reception device (103), wherein the first information includes information related to a transmission current of a transmission coil (213) of the wireless power transmission device (101) and mutual loss power;
receiving second information from the wireless power reception device (103), wherein the second information includes information related to a reception current of a reception coil (221) of the wireless power reception device (103), a phase difference between the reception current and the transmission current, and/or a load resistance of the wireless power reception device (103);
measuring a first transmission current of the transmission coil (213);
calculating first mutual loss power, based on the first information and the first transmission current;
calculating first loss power, based on the first mutual loss power and the second information, wherein the first loss power is loss power generated by magnetic flux of the transmission coil (213), magnetic flux of the reception coil (221), and mutual magnetic flux connected between the transmission coil (213) and the reception coil (221);
measuring second loss power between the wireless power transmission device (101) and the wireless power reception device (103); and
identifying a foreign object, based on a difference between the first loss power and the second loss power being greater than or equal to a reference value.

15. A non-transitory computer-readable storage medium storing at least one instruction, wherein the at least one instruction, when executed by at least one controller (215), comprising processing circuitry, of a wireless power transmission device (101), causes the wireless power transmission device (101) to perform at least one operation, the at least one operation comprising:
receiving first information from a wireless power reception device (103), wherein the first information includes information related to a transmission current of a transmission coil (213) of the wireless power transmission device (101) and mutual loss power;
receiving second information from the wireless power reception device (103), wherein the second information includes information related to a reception current of a reception coil (221) of the wireless power reception device (103), a phase difference between the reception current and the transmission current, and/or a load resistance of the wireless power reception device (103);
measuring a first transmission current of the transmission coil (213);
calculating first mutual loss power, based on the first information and the first transmission current;
calculating first loss power, based on the first mutual loss power and the second information, wherein the first loss power is loss power caused by magnetic flux of the transmission coil (213), magnetic flux of the reception coil (221), and mutual magnetic flux connected between the transmission coil (213) and the reception coil (221);
measuring second loss power between the wireless power transmission device (101) and the wireless power reception device (103); and
identifying a foreign object, based on a difference between the first loss power and the second loss power being greater than or equal to a reference value.
